(19) Europäisches Patentamt
European Patent Office
Office européen des brevets

(11) **EP 2 916 470 B1**

(12) **FASCICULE DE BREVET EUROPEEN**

(45) Date de publication et mention de la délivrance du brevet:
**02.11.2016 Bulletin 2016/44**

(51) Int Cl.:
**H04B 7/185** (2006.01)

(21) Numéro de dépôt: **15157474.6**

(22) Date de dépôt: **03.03.2015**

(54) **Procédé de détection d'un déséquilibrage et de calibration d'un amplificateur multiport d'un satellite de télecommunications.**

Verfahren zur Detektion eines Ungleichgewichts und zur Kalibrierung eines Multiport-Verstärkers eines Telekommunikationssatelliten

Method for detecting an imbalance and for calibrating a multiport amplifier of a telecommunications satellite

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.03.2014 FR 1451739**

(43) Date de publication de la demande:
**09.09.2015 Bulletin 2015/37**

(73) Titulaire: **Eutelsat S.A.**
**75015 Paris (FR)**

(72) Inventeurs:
• **Arcidiacono, Antonio**
**75015 Paris (FR)**
• **Finocchiaro, Daniele Vito**
**75015 Paris (FR)**
• **Le Pera, Alessandro**
**92130 Issy-Les -Moulineaux (FR)**
• **Brand, Yan**
**92150 Suresnes (FR)**

(74) Mandataire: **Cabinet Camus Lebkiri**
**25 rue de Maubeuge**
**75009 Paris (FR)**

(56) Documents cités:
**US-A1- 2003 017 827 US-A1- 2010 148 860**

## Description

## DOMAINE

Le domaine de l'invention concerne les méthodes de détection du déséquilibrage et de la calibration d'un amplificateur multiport d'un satellite de télécommunications.

Le domaine de l'invention s'applique aux tests et aux calibrations d'un amplificateur multiport comportant une pluralité de canaux d'amplification permettant de décomposer, amplifier et recomposer des signaux entre au moins un port d'entrée et un port de sortie. Le domaine s'applique aux mesures de déséquilibrages et aux calibrations d'un amplificateur multiport dénommé MPA autant lorsque le satellite est en phase de tests précédent la mise en orbite finale que dans une phase opérationnelle à tout moment de sa durée de vie.

Le domaine de l'invention concerne les tests pouvant être effectués sans interruption de services tout en minimisant les effets d'interférences des systèmes voisins ou des interférences pouvant être causés par son propre système.

## ETAT DE L'ART

Lorsqu'un satellite de télécommunications est lancé dans son orbite opérationnelle, un certain nombre de tests doivent être effectués pour s'assurer que toutes les fonctionnalités sont validées avant sa mise en état opérationnelle.

Il arrive également qu'un certain nombre de tests doivent être conduits pendant la phase opérationnelle du satellite. Ces tests doivent préférentiellement être conduits sans interruption de service notamment vis-à-vis des opérateurs exploitant des voies de diffusions transitant par le satellite.

Les satellites de télécommunications assurent généralement une fonction de répéteur, c'est-à-dire qu'ils retransmettent dans une zone prédéfinie un signal envoyé au satellite par exemple pour une application de diffusion Tv.

Le satellite comprend un ensemble d'équipements formant par exemple un système de commandes, de traitements, d'amplification, d'adressage et de diffusion de signaux.

Un équipement particulièrement sensible est la chaine d'amplification qui peut comprendre un ou plusieurs canal(aux) d'amplification correspondant à une démultiplication des capacités du satellite. Ces canaux sont appelés des « chemins » lorsqu'ils permettent de décomposer et recomposer des signaux arrivant aux ports d'entrée du MPA. Le MPA comprend des composants notamment d'une matrice dite « de Butler » permettant d'amplifier et déphaser des composantes divisées par un bloc d'entrée et de les recomposer par un bloc de sortie aux ports de sortie. Chaque voie de transmission est allouée à un port d'entrée et un port de sortie.

Les signaux d'une voie peuvent donc être, en entrée du MPA, décomposés dans différents chemins et recomposés après amplification en sortie pour être acheminés vers une antenne d'émission de ladite voie.

Actuellement, différentes solutions de répéteur intègrent un amplificateur multiport à bord d'un satellite de télécommunications. Un chemin d'amplification d'un répéteur d'un satellite comprend généralement un tube d'amplification à ondes progressives. Il s'agit d'un amplificateur à large bande avec un très faible bruit de fond. Généralement, un satellite de télécommunications comporte un MPA permettant de traiter plusieurs chemins permettant d'amplifier des composantes de signaux provenant de différentes voies d'une certaine largeur de bande de fréquences. Chaque voie peut être « louée » ou utilisée par des diffuseurs ou opérateurs. Il est donc important que chaque chemin amplifiant et déphasant les composantes d'un signal d'entrée du MPA soit calibré de sorte à offrir une fonction d'orthogonalité entre les composantes divisées dans les différents chemins du MPA.

Les amplificateurs multiport sont particulièrement utilisés pour des missions nécessitant la couverture d'une pluralité de spots, désignant chacun une station terrestre. Le satellite permet l'émission d'une pluralité de faisceaux descendants générés à partir d'une gestion de puissances adaptée à chaque voie et une gestion d'attribution de ports d'entrées et de de sorties et l'acheminement des signaux aux antennes du satellite. Ces solutions permettent une flexibilité quant à l'allocation de la puissance nécessaire sur chaque port de sortie d'un amplificateur multiport.

Les amplificateurs multiport sont communément appelés dans l'état de l'art un « MPA », dont l'acronyme dans la terminologie anglo-saxonne signifie « Multi-Port Amplifier ».

Généralement, un MPA comprend pour chacun de ses chemins un tube à ondes progressives, plus connus sous l'acronyme TWTA. Nous rappelons que le TWTA est un tube à vide utilisé en hyperfréquences pour réaliser des amplificateurs de faible, moyenne ou forte puissance. Il permet de réaliser des amplificateurs à bande large et à très faible bruit de fond. Il convient particulièrement bien pour les amplificateurs des satellites de communication.

En outre, un MPA comprend un réseau de formation de faisceaux permettant d'élaborer un ou plusieurs faisceau(x) émis avec une puissance, une phase et une direction données. Un exemple d'un tel réseau communément utilisé est une matrice de Butler ayant N entrées et N sorties et une configuration spécifique de chemins comprenant des amplificateurs et des déphaseurs et permettant d'obtenir une configuration de déphasage et d'amplification des composantes issues de signaux en entrée du MPA qui sont divisés pour obtenir un ou des signal(aux) de sortie du MPA souhaités.

Dans un fonctionnement nominal, si une voie est définie entre le port d'entrée N°1 et le port de sortie N°1, alors un signal acheminé au port d'entrée N°1 est uniquement présent sur le port de sortie N°1. La particularité d'un MPA est que les signaux d'une même voie sont déphasés dans chacun des chemins selon un plan définissant les déphasages d'un chemin à l'autre. Dans chaque chemin, les signaux déphasés sont amplifiés un amplificateur de type TWTA. En pratique, une conception choisie d'un réseau de formation et de recomposition de faisceaux peut être assurée par une matrice de Butler. Cette dernière réalise une fonction dite « fonction unitaire ». La fonction unitaire contribue à la formation d'un faisceau recomposé à une sortie de la matrice et potentiellement à la formation de N faisceaux recomposés à chacune des sorties.

Un avantage est que chaque TWTA actif contribue à l'amplification de signaux de différentes voies. Si une pluralité de signaux, séparés en fréquences, sont routés aux différentes entrées d'une matrice, chaque TWTA amplifie les signaux de chaque voie.

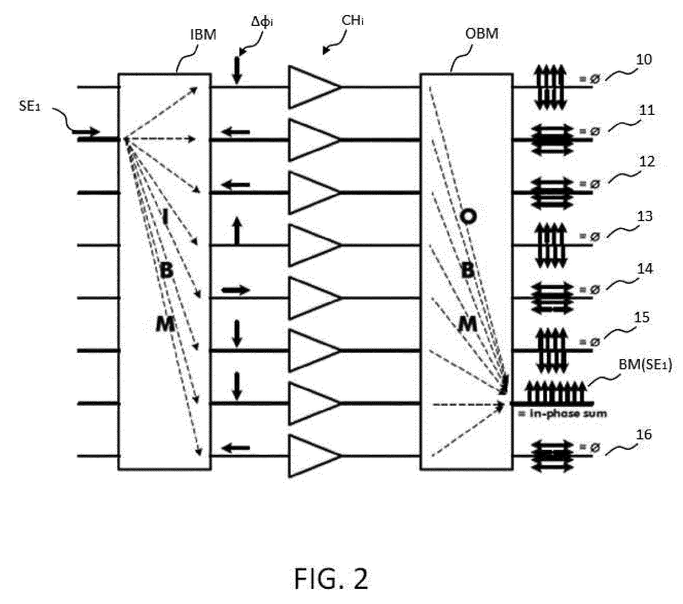

Lorsqu'un MPA est bien calibré, les signaux acheminés à un premier port d'entrée d'une voie ne sont présents qu'en sortie d'un premier port de sortie. Un problème survient lorsque la calibration entre les différents chemins du MPA n'est pas bien effectuée. En effet, une dérive en phase et/ou en amplitude des composantes entre les différents chemins peut conduire à rendre des résultantes de composantes de signaux en sortie du MPA non nulles alors qu'une configuration du MPA prévoir que ces dernières devraient être sensiblement nulles en sortie des autres ports de sortie. Ceci résulte d'une fonctionnalité d'une matrice de Butler telle que détaillée à la figure 2 qui permet d'annuler des composantes de signaux en opposition de phases en sortie du MPA. Ce problème est généralement nommé déséquilibrage du MPA.

Un déséquilibrage d'un MPA peut provoquer différentes conséquences dont :

- la réduction de la puissance d'un signal principal en sortie d'un port de la matrice car la sommation des composantes en phase sont légèrement déphasées;
- la réduction de la puissance d'un signal principal en sortie d'un port de la matrice causée par une différence de gain entre différents chemins d'un MPA ;
- la création de niveaux de signaux non négligeables, appelés fuites, en sorties de certains ports à cause d'une dérive du déphasage qui ne rend plus une résultante de composantes sommées entre elles en opposition de phases sensiblement nul.

Une limite communément acceptée est que la puissance des fuites doit être de l'ordre d'une puissance de 25dB inférieure à la puissance du signal principal sur la même voie.

Une manière aujourd'hui de résoudre le problème du déséquilibrage d'un MPA est de paramétrer les phases et amplitudes de chaque voie TWTA. Mais un problème lié à la dé-calibration ou le déséquilibrage des voies reste présent avec le vieillissement des modules TWTA ou encore du vieillissement des entrées et sorties d'une matrice de Butler ou d'autres composants.

Un autre inconvénient de cette solution est que lorsqu'un TWTA est défaillant et qu'un second TWTA est choisi pour le remplacer il n'est pas préalablement calibré en amplitude et en phase vis-à-vis des autres TWTA du MPA.

Il est donc impératif de mesurer les déséquilibrages en amplitude et en phase d'un chemin du MPA vis-à-vis des autres chemins d'amplification pour corriger la calibration dynamiquement. Enfin, un des problèmes rencontrés majeur est d'effectuer des mesures et une re-calibration sans perturber les communications en cours du MPA sur chacune des autres voies.

Une première solution connue consiste en des mesures effectuées à bord du satellite et transmises au sol dans une architecture dite de « boucle ouverte ». Dans cette solution la calibration d'un chemin du MPA est réalisée en effectuant des mesures sur les signaux de sorties de la matrice. On utilise alors des détecteurs RF à bord qui sont connectés au moyen d'un ou plusieurs coupleur(s) à des ports non utilisés par les transmissions relayées dans le satellite. Les détecteurs RF permettent de mesurer les niveaux de puissance des signaux en sortie des ports non utilisés. Les mesures sont effectuées sur chaque port de manière indépendante l'une de l'autre. Les mesures sont ensuite transmises à une station au sol au moyen de la liaison de télémétrie. Par exemple, une augmentation du niveau RF mesurée à la sortie d'un des ports vis-à-vis du niveau injecté traduit une dégradation de la calibration du MPA.

Un problème de cette solution est qu'elle dépend de la configuration opérationnelle choisie notamment sur le choix des niveaux d'entrées des signaux de test émis. Les mesures envoyées à une station sol peuvent ne pas être utilisables ou exploitables pour en déduire une re-calibration à effectuer. L'inconvénient majeur de cette solution est la dépendance du test à la configuration opérationnelle choisie.

Une seconde solution consiste en des mesures effectuées à bord du satellite et transmises au sol dans une architecture dite de « boucle fermée ». Un ou des signaux de test est/sont généré(s) à bord au moyen d'un DSP et est/sont injecté(s) dans un ou plusieurs ports d'entrées de la matrice. Les signaux en sortie des ports de sortie sont collectés via un ou des coupleur(s) calibré(s). Les signaux d'entrée sont également injectés au moyen d'un coupleur calibré sur les ports d'entrée de la matrice. Les sorties de la matrice peuvent être rebouclées sur le DSP de sorte que ce dernier ajuste les déphasages et les différences d'amplitude du signal généré à l'entrée de la matrice.

Un tel système comporte l'inconvénient d'être couteux. En outre, il est nécessaire d'embarquer une architecture complexe à bord du satellite notamment en prévoyant un DSP spécialement conçu pour effectuer ces tests de calibration. De ce fait, les composants engagent un poids supplémentaire à bord du satellite.

Une troisième solution consiste à directement recevoir les signaux émis sur les canaux à tester/ à calibrer dans une pluralité de stations au sol. La bande de fréquences et la directivité des antennes sont alors choisies de sorte à permettre ces transmissions depuis le satellite. Un exemple d'implémentation consiste par exemple à choisir une station terrestre principale sur laquelle est émis un signal principal depuis le satellite. L'antenne et la voie correspondante du satellite sont configurées pour émettre ce signal principal sur une station prédéfinie. Par ailleurs, on choisit une pluralité de spots géographiquement distincts de la station principale chacune correspondant à l'émission sur une voie du MPA. Ce procédé consiste à mesurer les pertes de lignes de la voie principale sur au moins une autre voie en mesurant dans chacun des spots la puissance reçue correspondant aux signaux de la voie principale. Pour cela, les niveaux RF sur chacune des voies sont mesurés au sol dans chaque spot. Après reconstitution des signaux, aux atténuations d'antenne près, il est possible de déduire les pertes de lignes causées par le MPA. Des comparaisons des signaux reçus permettent de déduire et d'isoler les pertes causées par un déséquilibrage d'une ou plusieurs voies du MPA.

Un inconvénient majeur de cette solution est qu'elle perturbe les télécommunications en cours du satellite lorsqu'il est dans une configuration de fonctionnement opérationnel.

Un example de calibration d'un MPA est décrit dans US2010/0148860.

En conclusion, les solutions aujourd'hui permettant de mesurer un déséquilibrage du MPA et de corriger ces déséquilibrages sont soient couteuses, soient difficiles à mettre en oeuvre et perturbantes pour les communications opérationnelles en cours lorsque le satellite est opérationnel.

**RESUME DE L'INVENTION**

L'invention permet de résoudre les inconvénients précités.

Un objet de l'invention concerne un procédé de détection d'un déséquilibrage d'un amplificateur multiport MPA destiné à être embarqué sur un satellite, l'amplificateur multiport comprenant une pluralité de chemins, chaque chemin étant configurable en gain et en phase, l'amplificateur multiport MPA comprenant une pluralité de ports d'entrées et une pluralité de port de sorties, chaque port d'entrée étant associé à un port de sortie pour former un canal de transmission appelé « voie », chaque port de sortie étant reliée à une antenne du satellite. Une première voie est configurée en fréquence dans un canal de transmission définissant une première bande utile pour recevoir des signaux en provenance d'une station émettrice au sol et les retransmettre après amplification dans l'amplificateur multiport MPA

vers une première station terrestre d'une première zone géographique, un second port de sortie d'une seconde voie étant configuré pour émettre via une seconde antenne vers une seconde station terrestre d'une seconde zone géographique.

Le procédé comprend :

- une transmission d'un premier signal de test modulé par étalement de spectre de la première station émettrice vers la première voie de l'amplificateur multiport, le premier signal de test étant généré dans au moins la bande utile de la première voie ;
- une réception par la seconde station réceptrice configurée en fréquence pour recevoir des signaux émis par la seconde antenne reliée à la seconde voie de l'amplificateur multiport, lesdits signaux étant susceptibles de comprendre une réplique du premier signal de test ;
- la détection et la mesure d'au moins une puissance de signaux reçus correspondant à une réplique du premier signal de test ayant fuité en sortie du second port de sortie ;
- un calcul d'au moins une valeur de déséquilibrage du MPA à partir de la mesure de la puissance de la réplique du premier signal de test reçue dans la seconde station terrestre.

Avantageusement, le MPA comprend une matrice de Butler comprenant :

- un module d'entrée permettant à partir du premier signal de test de générer une pluralité de composantes déphasées et de même amplitude vers une pluralité de chemins reliant le module d'entrée à un module de sortie;
- une pluralité de chemins comprenant chacun au moins un amplificateur de signaux ;
- un module de sortie permettant de diviser et recomposer les composantes entrantes déphasées et amplifiées de sorte à délivrer :

    o dans un port de sortie donné, un signal non nul amplifié correspondant au premier signal d'entrée à transmettre à la première station terrestre et ;
    o dans les autres ports, des résultantes des composantes du premier signal de test sensiblement nulles aux erreurs de calibrations près.

Avantageusement, le premier signal de test est un signal radiofréquence modulé par une séquence de bits de données codée par une séquence de pseudo bruit PN en bande de base, la séquence PN comprenant une taille N de symboles et un taux de codage $T_{Symbol}$.

Avantageusement, la séquence de pseudo bruit PN est choisie parmi une famille de codes ayant chacune une propriété d'orthogonalité.

Avantageusement, l'orthogonalité d'une séquence correspond au résultat d'une autocorrélation de deux mêmes séquences dont l'une est décalée temporellement avec l'autre d'au moins la durée d'un symbole, le résultat de l'autocorrélation présentant un niveau sensiblement obtenu dans le niveau de bruit.

Avantageusement, la longueur N de la séquence de pseudo bruit PN est calculée de sorte à obtenir un gain d'encodage supérieur à un seuil minimal, le gain d'encodage étant défini par le rapport entre le taux de codage d'un symbole d'une séquence de pseudo bruit PN et le taux de codage d'un bit de données d'une séquence de bits de données.

Avantageusement, le pic de l'autocorrélation d'une séquence de pseudo bruit est d'une valeur normée de 1 et qu'en dehors du pic de corrélation la valeur de la fonction d'autocorrélation est de l'ordre de 1/N.

Avantageusement, la séquence de pseudo bruit PN est choisie parmi la liste suivante : {un code de type Gold codes, un code de type « Maximum Lengh Sequence », un code de type Walsh-Hadamard codes}.

Selon un second mode de réalisation, une première valeur seuil d'isolation entre la première antenne de la première voie et la seconde antenne de la seconde voie est respectée de sorte que la puissance reçue des signaux de la première antenne au niveau de la seconde station de réception soit considérée comme négligeable vis-à-vis de la puissance des signaux reçus pas la seconde station de réception en provenance de la seconde antenne.

Dans ce second mode de réalisation, au moins deux stations réceptrices sont utilisées pour recevoir les signaux. Un avantage de ce mode de réalisation est de s'affranchir de la mise en oeuvre d'un retardateur dans une des voies du satellite. En revanche, il est nécessaire de s'assurer d'un certain niveau d'isolation des signaux reçus dans une station en provenance d'une antenne du satellite vis-à-vis des signaux émis des autres antennes.

Avantageusement, l'écart de puissance entre les signaux reçus par la seconde station en provenance de la première antenne et les signaux reçus pas la seconde station en provenance de la seconde antenne est supérieure à un seuil prédéfini.

Avantageusement, la première valeur seuil d'isolation est définie en comparant les puissances reçues dans un récepteur de la seconde station entre les signaux provenant d'une part de la première antenne et d'autre part de la seconde antenne.

Avantageusement, les signaux en sortie d'au moins deux antennes ($T_{x1}$, $T_{x2}$) du MPA sont polarisés avec différentes polarisations de sorte à introduire entre les deux antennes correspondantes une isolation supplémentaire.

Selon un second mode de réalisation :

- un retard à la sortie de l'une des voies du MPA est introduit de sorte à retarder les signaux en sortie du port de sortie ($P_{S1}$, $P_{S2}$) de la voie correspondante;

- une unique station terrestre permet de recevoir les signaux en sortie de chaque port de sortie, l'orientation des premières et secondes antennes permettant la réception des signaux des premières et secondes voies au niveau de la station terrestre.

Un avantage de ce second mode de réalisation est de permettre de récupérer les signaux dans une même station réceptrice.

Avantageusement, la durée du retard généré sur les signaux transmis est supérieure à une durée minimale correspondant à la période d'un symbole de la séquence PN du premier signal de test.

Avantageusement, le retard est introduit par un retardateur en sortie d'une des voies du MPA.

Avantageusement, le retardateur est une ligne à retard dont la longueur est dimensionnée pour introduire un retard souhaité.

Avantageusement, l'une des voies du MPA est raccordée à une antenne de télémétrie ou une antenne cornet et que au moins un retardateur est agencé entre la voie et l'antenne de télémétrie ou de cornet.

Avantageusement, un retard est généré au moyen d'une configuration d'un réseau de formation de faisceaux couplés avec les ports de sortie du MPA de sorte à attribuer pour chaque port de sortie des signaux comportant un déphasage prédéfini.

Avantageusement, le récepteur de la première station terrestre procède à une fonction d'autocorrélation des signaux reçus de chacune des voies sur une fenêtre de temps prédéfinie de sorte à discriminer la présence de chacune des séquences PN en réception, la discrimination des deux séquences résultant d'une isolation obtenue grâce au retard injecté dans l'une des voies du satellite.

Avantageusement, le premier signal de test est transmis sur une voie dans la même bande de fréquence que des signaux utiles de télécommunications.

Avantageusement, les étapes sont réitérées successivement entre différentes voies du MPA.

Un autre objet de l'invention concerne un procédé de calibration d'un amplificateur multiport MPA d'un satellite. Le procédé comprend :

- une mesure d'un niveau de puissance de la réplique du premier signal de test sur un récepteur d'une station terrestre au moyen du procédé de détection d'un déséquilibrage d'un amplificateur multiport MPA de l'invention;

- une génération d'au moins une consigne de calibration déduite des mesures de puissances du signal comprenant la réplique du premier signal de test ;

- une transmission de ladite au moins une consigne de calibration au satellite.

Avantageusement, au moins une consigne de calibration comprend au moins une consigne de déphasage et/ou une consigne de gain.

Avantageusement, le récepteur de la station réceptrice, mesurant la puissance d'un signal correspondant à une réplique du premier signal de test en sortie d'une seconde voie, transmet à une station de contrôle les données de puissances collectées de sorte à ce que la station de contrôle transmette un signal de commande au satellite visant à reconfigurer le MPA avec les consignes de gain et/ou de déphasage générées.

Un avantage de ce procédé de calibration est d'être compatible d'un fonctionnement opérationnel du satellite. Les transmissions d'opérateurs peuvent être ininterrompues pendant le procédé de calibration. Un avantage est que l'émission du signal de test de perturbe pas les transmissions opérationnelles.

La calibration peut être effectuée par l'antenne de télémétrie, de ce fait les transmissions opérationnelles ne sont pas perturbées par le signal de calibration.

## BREVES DESCRIPTION DES FIGURES

D'autres caractéristiques et avantages de l'invention ressortiront à la lecture de la description détaillée qui suit, en référence aux figures annexées, qui illustrent :

- figure 1 : différentes réponses à des fonctions d'autocorrélation basées sur différentes longueurs de séquences de pseudo-bruits;

- figure 2 : un exemple d'une matrice de Butler utilisée pour mettre en oeuvre un MPA ;

- figure 3A : un schéma de principe des moyens à mettre en oeuvre pour effectuer une transmission d'un signal d'une première station émettrice vers le satellite en vue de réaliser le procédé de l'invention ;

- figure 3B : un exemple d'un MPA comprenant au moins deux voies principales;

- figure 4 : des courbes de puissances des signaux reçus par des stations correspondantes à l'exemple de la figure 3B terrestres selon leur position respective au regard du pointage des antennes des différentes voies ;

- figure 5 : un mode de réalisation de l'invention comprenant un retardateur de ligne sur l'une des voies d'un MPA, par exemple celui représenté à la figure 3A.

## DESCRIPTION

Dans la présente description, on nomme « des fuites de signaux » d'une voie à une autre voie d'un MPA, des signaux normalement transmis sur une voie principale par l'intermédiaire d'un premier port d'entrée se retrouvant amplifiés par une autre voie et ayant pour conséquence de diriger des signaux dans un autre port de sortie du MPA que celui qui était destiné à les recevoir.

Les fuites sont liées à une mauvaise isolation des chemins d'un MPA, ce qui signifie que des dérives des amplificateurs ou des déphaseurs introduisent des écarts de déphasages ou des écarts d'amplifications non maitrisées en sortie du MPA.

On différencie donc « un chemin » d'un MPA qui peut être configuré par un gain variable et un déphaseur et qui prend une signification du point de vue du signal traité dans ledit chemin, d'une « voie » qui comprend un port d'entrée et un port de sortie et qui est associé à une antenne de réception et une antenne d'émission.

Matrice de Butler / MPA.

La figure 2 représente un MPA comprenant une matrice de Butler comprenant 8 chemins $CH_i$ reliant un bloc d'entrée, appelé IBM signifiant « Input Butler Matrix » dans la terminologie anglo-saxonne, à un bloc de sortie, appelé OBM signifiant « Output Butler Matrix » dans la terminologie anglo-saxonne. Le bloc d'entrées IBM comprend des ports d'entrée $PE_i$. Chaque signal $S_{E1}$ entrant dans un port d'entrée du bloc d'entrée IBM est divisé en 8 composantes d'amplitudes équivalentes.

Selon d'autres modes de réalisation le nombre de ports d'entrée et de chemins de la matrice de Butler peut être adapté selon le cas traité.

La division du signal d'entrée introduit un déphasage $\Delta\phi i$ entre chaque composante du signal divisé. Chaque composante du signal d'entrée $S_{E1}$ constitue une réplique du signal entrant qui est déphasée les unes des autres selon un plan de déphasage qui est préétablit.

La matrice de Butler comprend des chemins $CH_i$ permettant de joindre le bloc d'entrée IBM et le bloc de sortie OBM, chacun des chemins $CH_i$ comprenant un amplificateur permettant d'amplifier chaque composante du même gain. Le bloc de sortie OBM permet de diviser à nouveau chacune des composantes amplifiées entrantes en 8 autres sous-composantes d'amplitudes équivalentes avec un nouveau déphasage. Un total de 64 signaux issus du signal d'entrée $S_{E1}$ sont générés au total.

Le bloc de sortie OBM est paramétré de sorte à obtenir la résultante de n'importe quelle combinaison des composantes précédemment divisées à un de ses ports de sortie du bloc de sortie OBM. Il est donc possible d'obtenir par sommation des annulations de signaux déphasés de sorte qu'une résultante donnée soit nulle ou des amplifications de signaux de même déphasage.

La figure 2 représente 8 sorties 10, 11, 12, 13, 14, 15, 16 et $BM(S_{E1})$ de la matrice de Butler. Dans cet exemple, la matrice de Butler est configurée de sorte à ce que les résultantes sommées des composantes aux sorties 10, 11, 12, 13, 14, 15 et 16 soient nulles ou quasiment nulles.

A titre d'exemple la sortie 10 représente deux composantes sommées ayant un déphasage opposé ce qui conduit mathématiquement à une résultante nulle.

La sortie $BM(S_{E1})$ correspond à une sommation des composantes en phase, c'est-à-dire comprenant le même déphasage, la résultante des composantes sommées est donc non nulle.

On comprend à la lumière de la figure 2, qu'une dérive d'un amplificateur ou d'un déphaseur d'un des chemins de la matrice de Butler peut conduire à des sommations non nulles à certaines sorties alors que la configuration de la matrice est paramétrée pour obtenir une annulation de la sommation des composantes. Ces dérives peuvent survenir avec un vieillissement des composants de la matrice de Butler.

L'invention permet donc une re-calibration du MPA en compensant les dérives de phases et/ou d'amplitudes pouvant survenir pendant toute la durée de vie du MPA. Ces compensations peuvent s'appliquer aux chemins du MPA, et/ou aux blocs d'entrée et de sortie de la matrice de Butler.

L'invention vise donc à résoudre le problème lié à l'isolation des voies du MPA causé par une dérive des déphaseurs et des amplificateurs de la matrice de Butler.

Dans la présente demande, on nomme donc « une voie » l'ensemble formé par :

- le port d'entrée d'un MPA,
- les différents chemins utilisés pour déphaser et amplifier les signaux entrants et ;
- le port de sortie dans lequel les signaux sont recomposés.

Une fuite est constatée lorsque des signaux entrants dans un port d'entrée donné se retrouvent sur un port de sortie n'appartenant pas à la voie associée au port d'entrée.

Voie principale / voie secondaire.

Aux fins d'une meilleure compréhension de l'invention, on distingue l'une des voies du MPA dite « principale », d'une « voie secondaire ». La « voie principale » est définie comme la voie ayant vocation à transmettre et relayer des signaux de tests pour mesurer le déséquilibrage du MPA. Les signaux de test ainsi transmis sont reçus au niveau du port d'entrée principal $P_{E1}$. Dans la présente description et les exemples décrits la voie principale correspond à la première voie $V_1$ qui relie le port d'entrée $P_{E1}$ au port de sortie $P_{S1}$. On parle indifféremment d'un premier signal de test $S_{E1}$ ou de premiers signaux de test $S_{E1}$.

On appelle une « voie secondaire » pour les signaux entrants dans le port principal de la voie principale, une voie dans laquelle des composantes des signaux utiles ont été amplifiés et sommés avec un écart de phase ou d'amplitude qui introduit des fuites non négligeables à la sortie d'un port d'une voie secondaire.

Par convention la voie $V_1$ est la voie principale recevant les signaux de test pour la re-calibration du MPA et les autres voies sont des voies secondaires. Le procédé de l'invention permet de mesurer les fuites en sortie de ces voies secondaires dues à une mauvaise calibration ou à une dérive d'une précédente calibration. Dans la présente description, la voie $V_2$ est utilisée pour décrire en détail les mécanismes de mesures des niveaux de fuites selon le procédé de l'invention. La voie secondaire correspond à la seconde voie $V_2$ qui relie le port d'entrée $P_{E2}$ au port de sortie $P_{S2}$.

Lorsqu'un MPA est calibré convenablement, les fuites de signaux principaux générés à la sortie d'un port secondaire doivent être minimisées au maximum. Dans le cas d'une calibration optimisée, les fuites deviennent négligeables du point de vue de la puissance générée parasitant les signaux utiles transitant sur la voie secondaire.

Lorsque des fuites sont causées par une dérive de la calibration initiale du MPA, des écarts de phase et/ou d'amplitude dans la matrice de Butler entrainent la formation de signaux issus des composantes du signal principal en sortie d'un autre port que le port principal de sortie.

Configuration opérationnelle.

Le procédé de l'invention comprend une première étape de transmission d'un premier signal $S_{E1}$ modulé par étalement de spectre d'une première station émettrice $ST_{E1}$ au sol vers un premier port $P_{E1}$ d'une voie principale, appelée première voie $V_1$ de l'amplificateur multiport MPA du satellite. La première voie $V_1$ est entendue comme la voie acheminant le signal utile $S_{E1}$ d'un premier port d'entrée $P_{E1}$ vers un premier port de sortie $P_{S1}$. Une configuration du MPA permet d'acheminer les composantes des signaux utiles dans la matrice de Butler qui seront sommées en phase à la sortie du premier port de sortie $P_{S1}$ du MPA. Les autres voies sont théoriquement configurées de sorte à produire une résultante nulle à la sortie des autres ports de sortie $P_{Sk}$ en ce concerne l'acheminent du premier signal $S_{E1}$. Le signal utile $S_{E1}$ produit en entrée du MPA différentes composantes du signal qui sont déphasés et amplifiés dans différents chemins du MPA et qui sont recomposés au port de sortie $P_{S1}$.

Le procédé de l'invention permet notamment de transmettre le signal de test $S_{E1}$ dans la bande utile de la première voie $V_1$. Ainsi le signal $S_{E1}$ modulé par étalement de spectre peut être transmis aux fins de tests de calibration en même temps qu'un signal utile de télécommunications transitant dans la même voie $V_1$ par exemple par un autre émetteur sans pour autant nuire à cette dernière transmission.

Le premier signal de test $S_{E1}$ peut comprendre une séquence de données codant une information numérique d'identification. Cette dernière est modulée par exemple par une séquence de pseudo bruit PN comme détaillé par la suite.

L'émetteur $E_1$ basé sur une station terrestre $STE_1$ émet un signal, noté $S_{E1}$, modulé par un modulateur MOD par étalement de spectre à séquence directe, connu sous l'acronyme DSSS signifiant dans la terminologie anglo-saxonne : « Direct Sequence Spread Spectrum ». Le signal est donc émis à faible puissance et perturbe peu les communications voisines et les communications transmises sur la même voie principale.

Le procédé de l'invention permet de mesurer en sortie de chaque port secondaire $P_{Sk}$ la partie du signal $S_{E1}$ qui a produit des fuites sur les autres voies.

Le signal émis $S_{E1}$ permet selon le procédé de l'invention d'évaluer le déséquilibrage entre deux voies et donc le déséquilibrage du MPA en comparant à la sortie de deux différents ports de sortie $P_{S1}$ et $P_{Sk}$ du MPA les amplitudes des signaux provenant des composantes sommées du premier signal $S_{E1}$. Le niveau des fuites du signal $S_{E1}$ sur un port de sortie $P_{Sk}$ dont les résultantes des composantes du signal d'entrée $S_{E1}$ devrait être sensiblement nulles permettent d'en déduire des paramètres de re-calibration des chemins du MPA.

Le procédé de l'invention permet en effet de mesurer les déséquilibrages entre les voies $V_1$ et $V_2$ notamment par la déduction de paramètre de déphasage et de gain des chemins du MPA. Le procédé de l'invention permet de mesurer le niveau des fuites au niveau de la liaison descendante du satellite vers une ou des stations terrestres de réception à partir desquelles les mesures de niveaux de signaux sont effectuées.

Le procédé de l'invention permet donc de mesurer et de quantifier la puissance d'un signal $SS_1$ émis par le satellite vers une station terrestre et de le comparer aux puissances des fuites également émises par ce même satellite vers une station terrestre. Selon les différents modes de réalisation de l'invention, les stations terrestres recevant le signal de test SS1 ayant été relayé par le satellite et les fuites peuvent être les mêmes récepteurs ou des récepteurs de différentes stations terrestres.

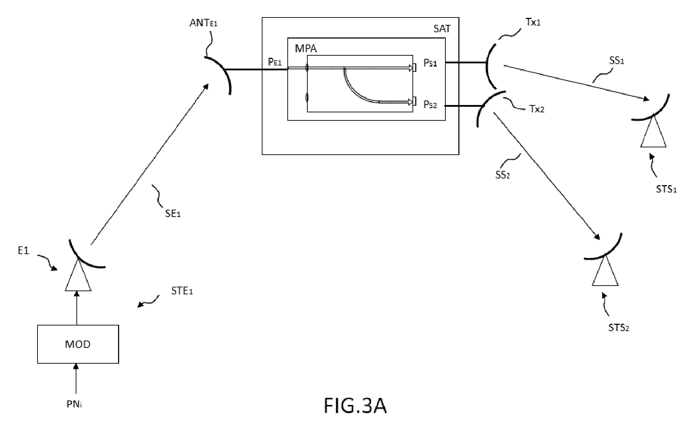

Les mesures peuvent être déduites à partir des signaux reçus sur des stations terrestres de réception telles que les stations $STS_1$ et $STS_2$ représentées à la figure 3A. Selon les modes de réalisation de l'invention, les stations peuvent :

■ être différentes et suffisamment éloignées pour assurer une isolation entre une voie principale et une voie secondaire ;
■ être identique lorsque le procédé permet de discriminer les signaux provenant de chaque voie indépendamment de l'une de l'autre.

Les mesures sont effectuées à partir :

■ d'une part, de données de contexte telles que les positions des stations terrestres et de modèle d'atténuation de signaux selon la position du satellite et ;
■ d'autre part, de données propres aux signaux reçus telles que leur puissance et les corrélations du signal modulé par étalement de spectre.

Modulation par étalement de spectre.

Le procédé de l'invention permet de définir une modulation par étalement de spectre particulièrement avantageuse au moyen de séquences de pseudo bruit PN. Les séquences de pseudo bruit PN permettent de générer un signal de test $S_{E1}$ qui peut être noyé en terme de la puissance dans une puissance reçue par le satellite d'un signal utile émis simultanément sur la même voie $V_1$. Les propriétés d'une modulation d'un signal par une séquence de pseudo bruit PN permet de discriminer le signal $S_{E1}$ à la réception par une démodulation appropriée.

En effet, un des avantages de l'utilisation des signaux modulés par étalement de spectre à séquence directe et qu'ils ne perturbent pas les transmissions courantes effectuées par le satellite, dont notamment les transmissions d'opérateurs et diffuseurs de contenus définissant des communications opérationnelles. Les interférences entre les signaux utiles et les signaux $S_{E1}$ sont, de ce fait, limitées par la nature des signaux modulés par étalement de spectre. Il n'y a donc pas de détérioration de la qualité de service des communications en cours lors d'une mesure d'un déséquilibrage d'un MPA selon le procédé de l'invention et lors de la procédure de calibration du MPA. La voie $V_1$ qui est testée par le procédé de l'invention peut donc être conjointement utilisée par un opérateur transmettant des signaux de données destinés par exemple à la diffusion Tv.

Comme énoncé précédemment, un exemple de signal généré par étalement de spectre à séquence directe présentant un intérêt particulier dans la méthode de l'invention est un signal de type séquence PN, dont l'acronyme anglo-saxon signifie « Pseudo Noise » qui peut être entendue comme une séquence de pseudo bruit dans la terminologie française.

Un premier avantage de la séquence PN est qu'elle peut être détectée par un récepteur qui démodule le signal reçu de la voie principale $V_1$ ou de la voie secondaire $V_2$. En appliquant le décodage de la séquence de données reçus sur un laps de temps donnée, la séquence PN étant connu, une fonction d'autocorrélation permet de détecter la présence ou non d'une séquence contenue dans le signal.

Un des problèmes que résout l'invention est notamment de discriminer une séquence PN en réception provenant d'une voie principale de celle contenue dans des signaux de fuites provenant d'une voie secondaire.

Introduction des deux modes de réalisation.

Selon les modes de réalisation, la séquence PN en réception au niveau d'une station terrestre peut être détectée de différentes manières pour résoudre ce problème. L'invention propose deux modes de réalisation principaux du procédé de l'invention reposant sur le même concept inventif utilisant :

■ dans un premier mode, le procédé permet d'introduire un retard généré sur l'une des voies secondaires de manière à discriminer au sol :

  o une séquence PN reçue provenant de la voie principale $V_1$ qui n'est pas retardée ;
  o une réplique d'une séquence PN comprise dans des signaux de fuites à la sortie d'un port secondaire.

■ dans un second mode, en assurant une isolation suffisante entre une voie principale et une voie secondaire et plus particulièrement des antennes connectées à ces voies, l'isolation permettant de discriminer au sol :

  o une séquence PN reçue provenant de la voie principale qui n'est pas retardée ;
  o une réplique d'une séquence PN comprise dans des signaux de fuites à la sortie d'un port secondaire.

Dans la présente description on entend une discrimination d'une séquence PN par une séquence PN modulé par les bits de données. Il est bien entendu qu'une opération de démodulation permet à partir d'une porteuse ou de porteuses de signaux d'extraire les données modulées en bande de base.

Premier mode : Retardateur.

Considérons en premier lieu le premier mode de réalisation. Lorsque le procédé de l'invention comprend la génération d'un retard sur une voie secondaire, le procédé permet de dimensionner ce retard en adaptant le rapport entre

■ la taille de la séquence PN ;
■ le retardateur sur le satellite.

Séquence PN / codage, PG.

Etudions en premier lieu, le choix de la séquence PN, de sa taille, et de son type de code. La taille de la séquence PN est définie par un taux de codage, noté $T_{symbol}$.
Le taux de codage $T_{symbol}$ peut être exprimé :

- soit en nombre de symboles générés par seconde pouvant être codés et transmis ou ;
- soit en nombre de symboles codant un bit de données, les bits de données étant transmis à un taux de bit par seconde, noté $T_{bit}$.

On introduit le gain d'encodage d'un bit par une séquence PN par la fonction PG :

$$PG = 10 \log (T_{symbol} / T_{bit})$$

Si par exemple la séquence PN comporte 10 symboles pour le codage d'un bit, alors PG = 10 dB.

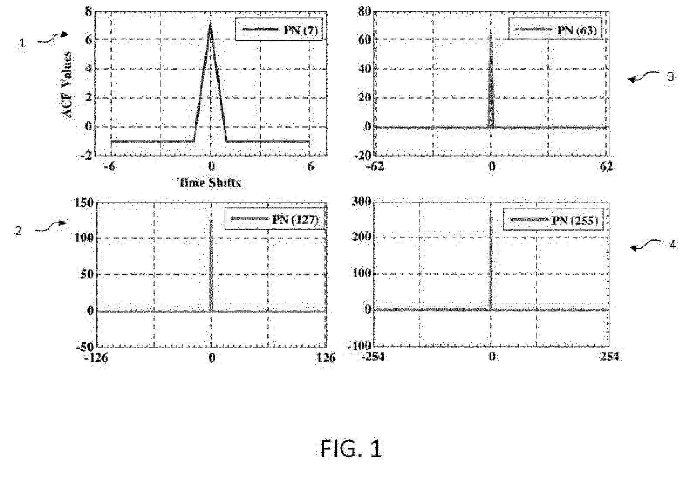

La figure 1 représente différentes séquences PN de différentes tailles, il s'agit d'un code dit « Gold code ».
Un avantage de l'utilisation des séquences PN est l'orthogonalité des séquences générées. En effet, le produit/ la corrélation d'une séquence PN avec une séquence quelconque est proche de zéro au sens que la valeur moyenne obtenue est proche de zéro, alors que l'autocorrélation d'une séquence PN avec elle-même donne un maximum comme cela est illustré sur la figure 1 par différents résultats de la fonction d'autocorrélation d'une fonction PN.
On constate que plus la séquence PN est longue plus le critère d'orthogonalité des séquences est important. Le maximum du pic de la fonction d'autocorrélation permet d'obtenir des pics élevés. Ceci constitue un premier avantage au niveau de la détection de la séquence PN qui peut être plus aisément retrouvée dans le signal reçu.
Un autre avantage peut être obtenu à la lumière de la figure 1 qui montre qu'un décalage d'au moins un symbole entre deux mêmes séquences auto-corrélées entre elles, permet d'obtenir un niveau du produit d'autocorrélation dans le niveau du bruit.
L'utilisation d'une séquence PN longue, c'est-à-dire ayant un taux de codage $T_{symbol}$ élevé permet d'obtenir un produit quasiment nulle de la fonction d'autocorrélation de deux séquences PN qui sont décalées d'au moins une durée symbole $D_{symbol}$ ou plus.
Ainsi l'introduction d'un retard sur une voie secondaire d'une durée d'au moins égale ou supérieur à celle d'un symbole $D_{symbol}$ permet en réception de dissocier les deux séquences PN provenant de la voie principale et d'une voie secondaire lorsque des fuites de signaux sont constatées.
Le procédé de l'invention permet donc d'adapter une séquence PN ayant un taux de codage $T_{symbol}$ élevé de sorte à diminuer la contrainte sur le retardateur sur le satellite.
En effet, lorsque le retardateur est une ligne à retard, sa longueur est proportionnelle au retard que l'on souhaite introduire.
Considérons un cas d'exemple dans lequel la configuration suivante est donnée :

- un canal de 72MHZ dans la bande Ku ;
- une fréquence porteuse descendante de 11 GHz
- la longueur d'onde est alors de $(3 \cdot 10^9)/(11 \cdot 10^8) = 2{,}72$ cm
- une séquence SSSD avec un taux d'encodage de 50 Mchip/s
- un facteur de roll-off de 6 = 0,4

On suppose PG = 60dB sur la chaine d'amplification qui correspondent à un taux de codage de bit de 50 bits/s.

La période d'un symbole est donc de 20ns dans cet exemple. Ce qui nous donne, pour une technologie de ligne à retard, une longueur de la ligne de l'ordre de 6 mètres pour une longueur d'onde de $220\lambda$.

On comprend donc que plus le PG est élevé, moins la longueur de la ligne à retard sera longue ce qui permet de réduire l'encombrement dans le satellite.

Séquence PN / Type de code.

De nombreuses séquences de codes peuvent être utilisées avec le procédé de l'invention telles que les séquences connues suivantes : Gold codes, « Maximum Lengh Sequences », Walsh-Hadamard codes et d'autres séquences encore.

Dans le mode de réalisation consistant à injecter un retard sur l'une des voies secondaires, le procédé de l'invention permet donc de limiter le retard à une durée symbole $D_{symbol}$ ou plus en bénéficiant des propriétés d'orthogonalité des séquences PN. Ces propriétés permettent en réception de discriminer une séquence PN provenant d'une voie principale de la même une séquence PN provenant d'une voie secondaire.

Le procédé de l'invention peut donc comprendre une optimisation de la valeur du gain d'encodage PG par la diminution de la vitesse de transmission d'un bit de données.

Le procédé de l'invention utilise la génération d'une telle séquence PN dans un signal émis $S_{E1}$ depuis une station émettrice $STE_1$ transmettant le signal à un satellite SAT. Dans le mode de réalisation impliquant la génération d'un retard, ce dernier sera introduit en sorite du port de sortie $P_{S2}$ du MPA par convention au regard de l'exemple illustré figure 3A.

Au niveau des récepteurs situés dans chaque station terrestre, les signaux sont détectés, démodulés, éventuellement horodatés. Les amplitudes des signaux et puissances sont calculées. Le signal principal est désigné comme celui empruntant la voie de transmission prévue à cet effet, c'est-à-dire la voie $V_1$ reliant le port d'entre $P_{E1}$ au port de sortie $P_{S1}$, en empruntant les différents chemins du MPA après décomposition et recomposition du signal reçu au port d'entrée $P_{E1}$. Les répliques contenues dans les fuites présentes sur au moins un autre port sont désignées comme les signaux issus du signal principal mais dont les recompositions en sortie d'un autre port n'ont pas généré de signaux nuls ou sensiblement nuls conformément à la calibration du MPA.

Dans le mode de réalisation générant un retard à la sortie de la voie $V_2$, la séquence PN en sortie d'un port secondaire est décalée d'au moins une durée symbole $D_{symbol}$ pour discriminer en réception cette séquence de la séquence PN de la voie principale. Le fait de décaler temporellement la réplique de la séquence principale en injectant un retard permet de détecter la réplique sans ambiguïté au niveau du récepteur de la station terrestre, lorsque les deux séquences sont reçues par le même récepteur par exemple.

Une autre manière de procéder et d'utiliser un algorithme de décodage de la séquence PN principale et des données utiles de la voie principale $V_1$. Une fois ces données démodulées, elles peuvent être utilisées pour déduire la présence de la même séquence PN provenant d'une voie secondaire dans le signal reçu en corrélant le signal reçu avec la séquence PN modulé par les bits de données. Mais cette méthode nécessite une implémentation logicielle spécifique pour le décodage.

Mise en oeuvre du retard.

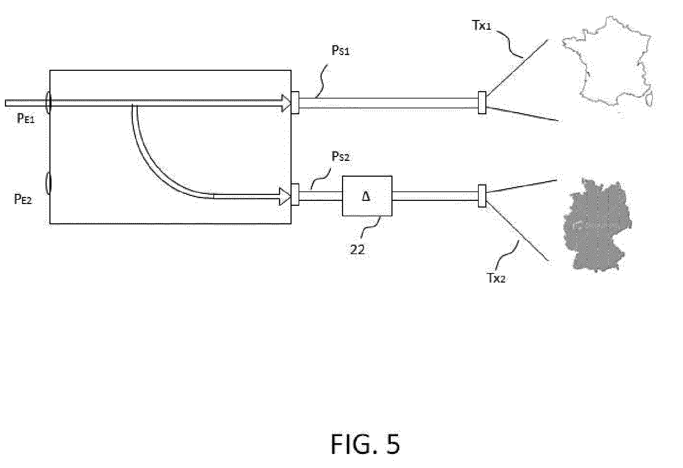

Détaillons ce premier mode de réalisation à la lecture de la figure 5 qui représente un retardateur 22 sur une voie secondaire.

Dans ce premier mode de réalisation, une première variante consiste à placer sur la voie $V_2$ ou à la sortie d'une voie secondaire du MPA un retardateur permettant d'introduire un retard de ligne. Ce dernier permet de retarder les signaux à la sortie du port de sortie $P_{S2}$.

A titre d'exemple, chaque port de sortie MPA pourrait être équipé de lignes à retard, qui sont des filtres, capables de fournir le retard de phase envisagée. Un moyen pratique consiste à utiliser une technologie de guides d'ondes. Il est alors nécessaire que les détériorations associées à ces filtres doivent être inférieures à 0,1 dB. Ceci permet de ne pas trop dégrader la puissance de sortie.

A cet effet, un retardateur 22 peut être agencé à la sortie du port de sortie $P_{S2}$ du MPA comme illustré sur la figure 5.

Plusieurs retardateurs.

Selon d'autres variantes de réalisation, des retardateurs sont présents à la sortie de chaque voie. Ces deniers comme détaillé précédemment permettent en réception d'effectuer des mesures de puissances des fuites de signaux dans une voie secondaire du MPA. Dans ce cas, chaque retardateur peut avoir un retard propre permettant d'isoler en réception une réplique de la séquence transmise originellement sur la voie principale et fuitant vers d'autres voies.

Un avantage de définir un retard différent sur chaque voie est de permettre d'ajuster de manière unique chaque voie vis-à-vis d'une voie de référence. Cela permet d'effectuer les tests que l'on souhaite sans perturber les liaisons de données utiles transitant pendant que le procédé de l'invention est réalisé. Il n'y a donc pas d'interruption de service du MPA pendant la phase de calibration et la phase préliminaire permettant de déduire les valeurs de calibration du MPA.

En conséquence, la partie des composantes du signal principal formant des fuites sur un port de sortie secondaire, par exemple de la voie $V_2$, sont retardées

d'un retard défini entre la voie $V_1$ et la voie $V_2$ : $\Delta T_{V2/V1}$.

Un seul retardateur.

Selon une autre variante, seule une voie est équipée d'un retardateur et toutes les mesures de calibration sont effectuées en comparant les mesures d'une voie à celle étant équipée du retardateur. Dans ce cas, il est préférable de mettre le retardateur sur une voie principale pour retarder les signaux principaux et ne pas retarder les fuites.

Selon ce premier mode de réalisation, le récepteur $STS_2$ reçoit deux signaux en provenance du satellite dont les puissances peuvent être isolées grâce à la prise en compte du retard.

La puissance mesurée relative à la partie du signal reçue correspondant aux fuites permet de déduire des valeurs de consignes de calibration en phase et en amplitude à appliquer au MPA.

Retard avec réseau de faisceaux.

Selon une seconde de réalisation n'utilisant pas de retardateur sur les voies, il est possible de bénéficier d'une configuration permettant de générer des retards sur chaque voies du MPA en utilisant un réseau de formation de faisceaux alloués à une configuration spécifique des ports de sorties du MPA. Par exemple, lorsqu'un réseau de formation de faisceaux est couplé avantageusement avec les ports de sortie du MPA et différentes couvertures de chaque antenne selon une configuration donnée de déphasage des signaux transmis sur chaque voie du MPA. Cette configuration permet de déphaser sur chaque voie les signaux d'un retard donné de manière à ce que chaque station terrestre visée reçoive un signal déphasé par exemple d'un multiple d'un retard $T_0$.

Si un retard de $T_0$ est introduit entre la première voie $V_1$ et la seconde voie $V_2$, chaque retard introduit dans les autres voies d'un MPA peut être, par exemple, un multiple du retard $T_0$. On a alors pour la voie $V_3$, un retard de $2 \cdot T_0$, pour la voie V4 un retard de $3\text{-}T_0$.

Retard avec port de sortie non utilisé par le MPA.

Enfin, une troisième variante permettant de générer des retards sur chacune des voies du MPA consiste en l'utilisation d'un port de sortie non utilisé par les communications du MPA. Ce port de sortie peut alors être configuré avec une ligne à retard de faible puissance qui est connectée à une antenne cornet qui est par exemple utilisée pour la liaison de télémétrie ou la transmission d'un signal Beacon.

La réplique de la séquence qui est retardée est reçue au niveau d'une station terrestre assurant la liaison de télémétrie.

Dans cette solution, chaque mesure d'écart de puissances des fuites de signaux est effectuée entre la voie principale testée et la voie connectée au port connecté à la ligne de retard et l'antenne cornet. Des valeurs de calibration du MPA sont alors déduites. Chaque voie peut alors être calibrée par rapport à la même voie de test utilisant l'antenne cornet. Cette solution présente l'avantage de nécessiter que de peu de modifications matérielles, excepté la ligne à retard à intégrer dans le port non utilisé.

Selon les cas de figures, une configuration d'activation d'un retard en sortie d'un port de sortie $P_{S2}$ d'une voie secondaire $V_2$ peut être déclenchée selon les procédures de tests engagées à des périodes données et des durées prédéfinies. Ainsi, il n'est pas nécessaire par exemple dans la dernière variante utilisant le cornet que la ligne à retard ne génère un retard en permanence sur tous les signaux transitant sur cette voie.

La solution permettant d'utiliser un port de sortie non utilisé du MPA aux fins de l'introduction d'un retard offre une solution efficace. Ce port de sortie peut être le second port $P_{S2}$. Dans ce cas, l'antenne Tx2 est une antenne cornet dans cet exemple.

De cette façon, le signal correspondant aux fuites amplifiés et émis par l'antenne cornet $TX_2$ via le port non utilisé $P_{S2}$, est noté $SS_2$. La réplique de séquence principale est décalée dans le temps de la durée nécessaire qui a été configurée dans la fonction de retardateur. Le signal $SS_2$ est transmis à une station terrestre destinée à recevoir les signaux de télémétrie par exemple.

Si le MPA n'est pas bien calibré, alors le récepteur de la station terrestre est en mesure de détecter une puissance de signaux reçus. Il est alors en mesure d'en déduire la présence d'une réplique de la même séquence PN transmise sur la voie principale grâce à l'introduction du retard sur la voie secondaire et grâce à la mise en oeuvre d'une fonction d'autocorrélation.

Une des solutions préférentiellement utilisée dans le cas de communication transitant sur la voie principal est celle consistant à introduire un retard en sortie du port $P_{S2}$ et d'utilisé un port de sortie du MPA non utilisé par les communications opérationnelles. On utilise alors $Tx_2$ qui est une antenne cornet comme détaillé dans cette troisième variante.

L'introduction du retard nous permet de s'affranchir du niveau d'isolation entre les voies. En effet, une isolation d'au moins 40dB entre la puissance reçue au sol de chaque voie est à minima nécessaire. Cette contrainte impose de recevoir les signaux dans deux stations différentes et suffisamment éloignées pour atteindre les contraintes d'isolation nécessaires.

Le retard peut être généré au moyen par exemple d'une ligne à retard, tel qu'un câble coaxial de faible puissance en sortie du port de sortie $P_{S2}$. Le signal retardé peut être atténué par le retardateur et le gain de l'antenne de télémétrie, également appelée « antenne cornet », qui est plus faible que le gain d'une antenne de radiocommunication connectée au MPA telle que l'antenne $T_{x1}$. Le gain de l'antenne de télémétrie est inférieur au gain de l'antenne $T_{x1}$, approximativement de 20 à 30db inférieure. De ce fait, la différence de puissance entre la séquence principale émise par $Tx_1$ et la réplique émise par $Tx_2$ en réception dans la station terrestre $STS_2$ peut être de 20dB + 20dB = 40dB.

Pour que la fonction d'autocorrélation reste performante dans ces conditions, il alors est nécessaire de dimensionner la taille N de la séquence de pseudo-bruit PN de sorte à maximaliser sa détection par le récepteur $STS_2$.

Analyse des signaux en réception.

Un troisième avantage de la méthode utilisant l'introduction d'un retard est qu'elle permet ne pas nécessairement décoder les signaux, la fonction d'autocorrélation appliquée aux signaux reçus sur une fenêtre de temps donné permettent :

- de détecter la présence de la séquence PN reçue et émise par la voie principale ;
- de détecter la présence de la même séquence PN répliquée provenant d'une voie secondaire lorsque des fuites ont lieus sur au moins un port secondaire $P_k$.

Ces détections peuvent être déduites du résultat des fonctions d'autocorrélation sans décodage des séquences.

Il n'y a donc pas une nécessité d'utiliser un algorithme de décodage ce qui permet d'éviter une étape d'analyse de données en réception. Seule la puissance du signal reçue peut être mesurée et les résultats des fonctions d'autocorrélation.

L'analyse de la puissance du signal reçu comprenant une réplique de la séquence issue d'une voie secondaire permet de déduire des paramètres de rééquilibrages du MPA.

Le procédé de l'invention peut s'appliquer à chaque voie secondaire en comparant les signaux reçus entre une voie secondaire et une voie principale.

Les déductions de paramètres de déphasage(s) et d'écart(s) de gain des amplificateurs du MPA sont obtenues par analyse des niveaux de puissance des fuites en sortie de chaque voie et donc au sol après réception des signaux émis par le satellite SAT.

Une étape de calcul permet de déduire les paramètres de rééquilibrage qui doivent être appliqués au MPA selon un procédé de calibration.

Une calibration du MPA peut alors être engagée lorsque le procédé de détection permet de déduire des valeurs de fuites en sorties de chaque voie.

2eme mode.

Selon un autre mode de réalisation, un retard n'est pas nécessairement introduit dans une voie secondaire pour discriminer la partie du signal correspondant au signal principal des fuites.

Comme déjà introduit précédemment, un problème rencontré dans ce cas-là est l'isolation des stations terrestre l'une de l'autre vis-à-vis des signaux qui ne leur sont pas destinés. Le procédé de l'invention permet dans ce second mode de réalisation de résoudre ce problème.

Ce mode de réalisation nécessite de recevoir les signaux provenant de la voie principale et les signaux d'une voie secondaire comprenant des fuites dans deux stations terrestres suffisamment isolées l'une de l'autre en fréquences. Les signaux reçus à chaque station comportant chacun la même séquence PN modulé par les bits de données peuvent donc être reçus simultanément et être analysés à postériori :

- soit en effectuant un décodage, une mesure de niveau et une comparaison des données démodulées ;
- soit par une fonction d'autocorrélation appliquée aux deux signaux reçus et horodatés et en analysant le pic de corrélation.

La figure 3A représente un émetteur $E_1$ d'une station terrestre $STE_1$. Un signal $S_{E1}$ est modulé par une séquence $PN_i$ de pseudo-bruit et transmise au satellite via une liaison montante. On considère alors une seconde voie $V_2$ connectée à un port de sortie $P_{S2}$. La première voie $V_1$ est connectée à un port de sortie $P_{S1}$.

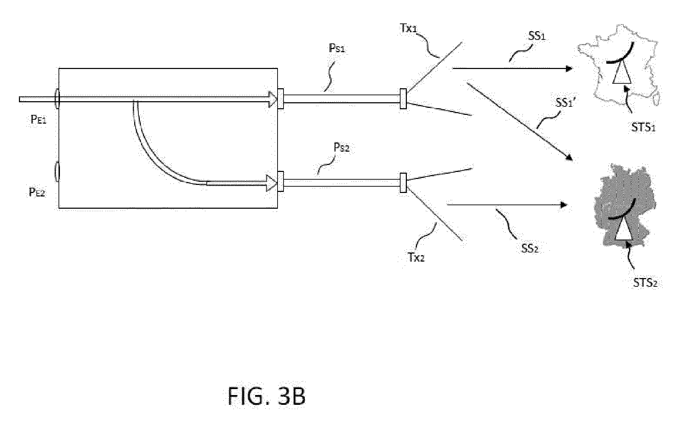

Chaque antenne de sortie $Tx_1$ et $TX_2$ est orientée selon une configuration de diffusion. La figure 3B propose un exemple de configuration permettant de mieux comprendre ce second mode de réalisation reposant sur une bonne isolation de la voie principale avec une voie secondaire. Par exemple, l'antenne de sortie $Tx_1$ connectée au premier port $P_{S1}$ est dirigée de manière à diffuser sur une zone en France FR alors que l'antenne de sortie $Tx_2$ connectée au second port $P_{S2}$ est dirigée de manière à diffuser une zone allemande DE. Le signal de sortie de l'antenne $Tx_1$ est noté $SS_1$ et le signal de sortie de l'antenne $Tx_2$ est noté $SS_2$.

L'exemple de la couverture de zones française et allemande sera pris pour détailler un cas d'étude permettant de mieux comprendre l'invention, mais le procédé de l'invention s'applique dès lors que deux stations de réception offre une isolation suffisante entre elles.

Le satellite SAT reçoit le signal $S_{E1}$ sur une antenne $ANT_{E1}$ de réception. L'antenne délivre le signal reçu sur un premier port $P_{E1}$ du MPA. Lorsque le MPA n'est pas calibré, des signaux recomposés en sortie de ports secondaires peuvent générer des fuites qui comportent une trace de la séquence $PN_i$ modulée par les bits de données. Les fuites sont générés selon les principes expliqués au regard de la figure 2 lors de la recomposition de composantes de signaux sommés en théorie en opposition de phase.

La mesure des puissances de fuites comprenant la séquence $PN_i$ peut être réalisée en analysant la puissance reçue sur la station $STS_2$. Cette analyse permet d'en déduire des valeurs de déséquilibrage et donc d'en déduire des consignes de calibration du MPA de la même manière que dans le premier mode de réalisation.

Dans l'exemple illustré à la figure 3B, lorsque l'on se situe sur une zone de réception en Allemagne, la figure 3B illustre qu'une partie $SS_1$' des signaux émis par l'antenne $TX_1$ des signaux $SS_1$ arrive au niveau du récepteur $STS_2$ dans la zone en Allemagne DE. Ceci est dû à une non-isolation à 100% entre zones de couvertures qui ne sont pas totalement disjointes du fait de la proximité géographique des zones. Par exemple, les villes frontalières entre l'Allemagne et la France seront plus sujettes aux conséquences d'une isolation insuffisante en recevant les signaux des deux antennes.

En Allemagne, lorsqu'aucun signal n'est injecté sur le port d'entrée $P_{E2}$, le récepteur $STS_2$ reçoit donc la somme :

- des signaux transmis par la première antenne $Tx_1$ et ayant étés atténués par la distance et l'inclinaison entre l'antenne $Tx_1$ du satellite et le récepteur situé en Allemagne ;
- des signaux ayant fuité de la première voie $V_1$ vers la seconde voie $V_2$.

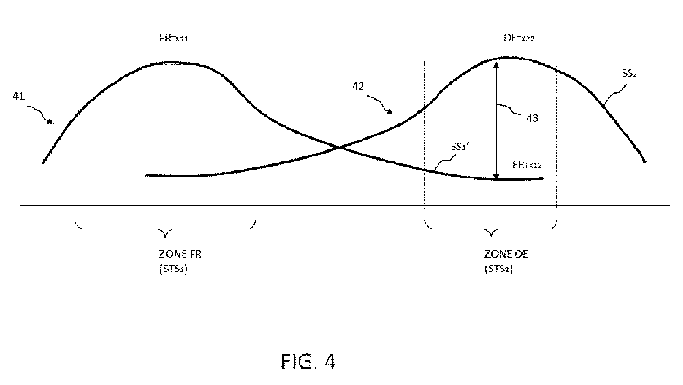

La figure 4 permet d'illustrer les niveaux de signaux reçus à chaque station terrestre.

La puissance reçue au niveau de la station terrestre $STS_2$ comprend donc :

- une première partie $SR_{STS2}(A)$ amplifiée par l'antenne $Tx_1$ mais isolée partiellement géographiquement et ;
- une seconde partie $SR_{STS2}(B)$ amplifiée par l'antenne $Tx_2$ issue des fuites du MPA causé par un déséquilibrage de ce dernier.

La courbe 41 représente la puissance du signal provenant de l'antenne $Tx_1$ qui est destinée à couvrir la zone située en France. On constate que la puissance est effectivement maximale dans la zone de couverture FR et que cette puissance diminue dans les zones voisines dont la zone DE située en Allemagne.

Identiquement, la courbe 42 représente la puissance du signal provenant de l'antenne $Tx_2$ destinée à couvrir la zone située en Allemagne. On constate que la puissance est effectivement maximale dans la zone de couverture DE et que cette puissance diminue dans les zones voisines dont la zone FR située en France.

Du point de vue d'un récepteur $STS_2$, situé en Allemagne dans la zone DE, il reçoit la somme de la puissance des signaux provenant des deux antennes dont $Tx_1$ et $Tx_2$.

Afin de mieux comprendre les courbes de la figure 4, on nomme :

- le gain $FR_{TX11}$ : le gain des signaux en sortie de l'antenne $Tx_1$ et arrivant au niveau du récepteur $STS_1$ et ;

- le gain $FR_{TX12}$ : le gain des signaux en sortie de l'antenne $Tx_1$ et arrivant au niveau du récepteur $STS_2$ ces signaux sont notés $SS_1$' et ;
- le gain $DE_{TX22}$ : le gain de l'antenne connectée à la seconde voie $V_2$ assurant la couverture de la zone allemande et donc du récepteur $STS_2$,
- la puissance reçue $SR_{STS2}$ : la puissance des signaux reçus au niveau du récepteur $STS_2$,
- les fuites $SS_{V1->V2}$ en sortie de l'antenne Tx2 provenant de la recomposition non nulle de composantes du signal $S_{E1}$ sur une voie secondaire.

On obtient :

$$SR_{STS2} = SR_{STS2}(A) + SR_{STS2}(B),$$

Avec :

$$SR_{STS2}(A) = (SS_1 \cdot FR_{TX12})$$

$$SR_{STS2}(B) = (SS_{V1->V2} \cdot DE_{TX22})$$

Lorsque le MPA est calibré parfaitement, c'est-à-dire qu'il n'y a pas de fuite de la voie V1 sur le port de sortie $P_{S2}$, en théorie on doit avoir :

$$SS_{V1->V2} \approx 0 \text{ et donc } SR_{STS2}(B) \approx 0$$

Dans ce cas, le récepteur $STS_2$ situé dans la zone allemande dans le même exemple que précédemment, reçoit uniquement le signal $SS_1$' en provenant de l'antenne $Tx_1$ et donc la puissance dénommée $SR_{STS2}(A)$. On précise que les signaux $SS_1$ et $SS_1$' sont identiques, seul le gain en réception de ces signaux diffère d'une station terrestre à une autre en fonction de la direction de pointage de l'antenne et de l'isolation de l'antenne.

Lorsque le MPA est déséquilibré, des signaux transmis par une voie secondaire comprenant la séquence PN modulé par les bits de données se retrouvent à la sortie d'un port secondaire $P_{S2}$. Les fuites, notées $SS_{V1->V2}$, sont non nulles et possèdent une puissance que l'on cherche à mesurer au niveau d'une station terrestre isolée de la station recevant les signaux provenant de la voie principale $V_1$.

Dans le même exemple que précédemment, le récepteur situé dans la zone en Allemagne reçoit une partie du signal provenant de l'antenne $Tx_1$ qui assure la couverture de la zone en France et une partie de signaux amplifiés par les amplificateurs de la voie $V_2$ provenant de la voie V1.

La figure 4 représente les deux parties de la puissance reçue des signaux $SS_1$' et $SS_2$ par le récepteur

STS$_2$.

Lorsqu'aucun signal utile n'est transmis sur la voie V$_2$, on a :

$$SS_2 = SS_{V1->V2}$$

En effet, seules les fuites des composantes déphasées du signal S$_{E1}$ sommées en sortie du MPA sont émises dans ce cas par l'antenne T$_{x2}$.

Le procédé de l'invention permet de mesurer la seule partie du signal reçu au niveau du récepteur STS$_2$ issue des composantes du signal principale de la voie V$_1$ qui se sont recomposées en sortie d'un port secondaire et formant donc des fuites sur le port de sortie P$_{S2}$. La mesure de ces fuites permet d'en déduire une valeur de déséquilibrage du MPA.

Les mêmes mesures peuvent être appliquées à chaque voie en prenant pour chaque mesure une voie principale de référence, dans notre cas nous avons pris V$_1$ et le port P$_{E1}$ comme le port recevant le signal principal de test pour la mesure du déséquilibrage du MPA.

Ce second mode de réalisation nécessite de choisir un seuil d'isolation entre les deux antennes Tx$_1$ et Tx$_2$ et donc une configuration des antennes T$_{x1}$ et T$_{x2}$ et leur orientation pointant deux stations terrestres suffisamment éloignées.

Lorsque l'isolation des signaux émis entre les deux voies est suffisante, la puissance reçue des signaux amplifiés par la voie principale V$_1$ et reçus dans le récepteur STS$_2$ sont négligeables au regard de la puissance des signaux provenant des fuites de signaux de la voie V$_1$ sur le port de sortie P$_{S2}$.

De manière concrète le ratio 43 peut être apprécié au regard de la figure 4. Lorsque la puissance du signal reçue par la station STS$_2$ est maximale, la puissance du signal SS$_1$' provenant de l'antenne TX$_1$ est négligeable.

Ce second mode de réalisation s'attache à définir une solution qui vise à maitriser l'isolation entre les antennes d'émission Tx$_1$ et Tx$_2$ du satellite.

En choisissant des stations de chaque zone suffisamment éloignée, par exemple « Brest » pour la France et « Berlin » pour l'Allemagne, les signaux en sortie du port P$_{S1}$ à destination de Brest dans la zone France perturberont très peu les signaux reçus dans une station située à Berlin dans la zone Allemagne. La puissance des signaux reçue à Berlin par l'antenne Tx$_2$ sera nettement supérieure à la puissance des signaux émis par Tx$_1$ et reçue à Berlin qui seront considérés de puissance négligeable.

On considère que les atténuations sont suffisamment fortes et donc les couvertures dans ces villes suffisamment disjointes pour considérer la puissance du signal SS$_1$' comme négligeable en réception du récepteur STS$_2$ située à Berlin.

Le procédé de l'invention permet de mesurer un déséquilibrage du MPA notamment en comparant la puissance des fuites d'une voie à l'autre.

Dans notre cas d'exemple, la puissance des signaux reçue à Berlin, soit la station STS$_2$, en provenance de la voie V$_1$ et du port P$_{S1}$ et donc de l'antenne Tx$_1$ doit être négligeable vis-à-vis de la puissance des signaux en provenance de la voie V$_2$ et du port PS$_2$ donc de l'antenne Tx$_2$ correspondant aux fuites des signaux de la voie V$_1$ vers la voie V$_2$.

Dans cet exemple on suppose qu'aucun signal n'est injecté dans le port d'entrée P$_{E2}$ de la voie V$_2$ destinée à émettre sur l'antenne Tx$_2$.

Les seuls signaux présents au port de sortie PS$_2$ seront les fuites de signaux injectés à l'entrée du port d'entrée P$_{E1}$ destinés à être transmis vie l'antenne Tx$_1$.

Considérons un cas d'exemple dans lequel le déséquilibrage du MPA est de 20dB.

Si l'isolation entre les antennes Tx$_1$ et Tx$_2$ permet d'avoir une différence de plus de 20dB entre elles, alors la puissance du signal SS$_1$' en réception à la station STS$_2$ sera négligeable vis-à-vis de la puissance reçue des fuites dues au déséquilibrage du MPA. Le choix des stations terrestres STS$_1$ et STS$_2$ prises comme suffisamment éloignées entre elles contribuent donc à isoler les deux antennes Tx$_1$ et Tx$_2$ l'une de l'autre.

Au niveau de la station terrestre STS$_2$ deux cas peuvent survenir :

- Soit aucun signal n'est détecté et le MPA set alors bien calibré, c'est-à-dire que le déséquilibrage du MPA est inférieur à un seuil acceptable ;
- Soit un signal est détecté et la séquence d'étalement de spectre est reçue. La puissance du signal reçue peut être détectée et mesurée. Dans ce cas, la connaissance du gain de l'antenne Tx$_2$ et la connaissance de l'isolation permet d'en déduire le déséquilibrage du MPA.

Dans un mode de réalisation, plusieurs zones de couvertures peuvent être atteintes avec l'antenne Tx$_2$. Les mesures de puissance reçue peuvent alors être relevées en différents points géographiques, c'est-à-dire dans différentes stations. Les résultats peuvent alors être consolidés par comparaison des puissances reçues dans différentes stations terrestres. Cela permet de valider et vérifiés avec plus de certitude les niveaux de déséquilibrages du MPA.

L'isolation entre les deux antennes Tx$_1$ et Tx$_2$ peut également être améliorée en attribuant des signaux d'une certaine polarisation à l'antenne Tx$_1$ et une autre polarisation à l'antenne Tx$_2$. Il peut s'agir par exemple de polarisations inverses ou orthogonales. Cette solution permet de minimiser les puissances reçues des signaux reçues à la station ST$_2$ en provenance de l'antenne Tx$_1$.

Un avantage de cette méthode est de ne pas nécessiter de modification matérielle du satellite.

Un des principaux avantages de l'utilisation d'un signal à étalement de spectre est qu'il est compatible d'un fonctionnement opérationnel permettant de réaliser ces tests tout en maintenant une continuité de service pour les opérateurs de télécommunication. En effet, les séquences d'étalement de spectre ne perturbent pas les signaux utiles transitant dans le MPA. Un avantage est qu'au niveau du récepteur de la station terrestre $STS_2$, les communications utiles peuvent être facilement traitées de sorte à ne retenir que la séquence reçue par étalement de spectre.

Cette propriété n'empêche pas le procédé de l'invention d'être compatible d'un mode dans lequel des communications utiles transitent sur la voie $V_2$. Dans ce cas, le MPA traite des signaux entrants dans le port d'entrée $P_{E2}$ et les achemine vers le port de sorties $P_{S2}$. En reprenant, l'exemple précédent avec une isolation de 20dB entre les deux antennes au niveau des stations sols, la valeur du déséquilibrage qui est détectable à la station $STS_2$ est de 20dB.

Calibration du MPA.

Différentes méthodes de l'invention permettent de mesurer la présence ou non d'un déséquilibrage du MPA. Lorsqu'un déséquilibrage du MPA est détecté dans une procédure de test, une valeur de calibration est déduite. La calibration par exemple des différents chemins du MPA peut être effectuée. Une calibration d'un chemin consiste par exemple en :

- l'introduction d'un déphasage d'un déphaseur variable de sorte à obtenir un plan de phases prédéfini entre chaque chemin et ;
- l'ajustement d'un gain variable d'un amplificateur de chaque chemin du MPA.

Identiquement la calibration des modules d'entrée IBM et de sortie OBM peuvent être calibrés selon les composants qui sont concernés.

La phase et/ou l'amplitude de chaque chemin du MPA peuvent donc être ajustées selon une ou des consigne(s). Le changement de phase ou d'amplitude d'un chemin est susceptible d'impacter généralement toutes les voies du MPA (liaison d'un port d'entrée avec un port de sortie).

Pour effectuer la calibration du MPA, des consignes de calibration en phase et/ou en amplitude doivent être transmis au satellite. Une station de contrôle permet de générer les consignes de calibration vers le satellite à partir des mesures de puissances relevées dans une station $STS_2$. Ces consignes peuvent être adressées au moyen de commandes de contrôle par exemple grâce à la liaison de télémétrie.

Les consignes de calibration peuvent être appliquées pour chaque chemin du MPA ou les modules d'entrée IBM et de sortie OBM. Chaque chemin peut être calibré l'un après les autres selon une itération des paramètres affectés à chaque composant, dont notamment les déphaseurs et les amplificateurs.

La calibration permet de corriger les déséquilibrages du MPA. Le déséquilibrage du MPA peut avoir été causé par l'utilisation redondante d'un amplificateur à tube TWTA d'un chemin du MPA ou encore un changement de temps de réponse d'un amplificateur TWTA ou la dérive de certains composants passifs des différents chemins du MPA.

Un plan de tests de mesure des déséquilibrages du MPA peut être conduit de sorte à générer un plan de calibration. La calibration peut ensuite être à nouveau testée selon le même procédé et être réajustée au besoin par une itération de la procédure de calibration.

Le procédé de l'invention peut s'appliquer à tous les MPA notamment ceux présents dans les satellites de diffusion et dont les satellites géostationnaires.

Le procédé de l'invention s'applique néanmoins à tout type de satellite comprenant un MPA.

**Revendications**

1. Procédé de détection d'un déséquilibrage d'un amplificateur multiport (MPA) destiné à être embarqué sur un satellite (SAT), l'amplificateur multiport comprenant une pluralité de chemins, chaque chemin étant configurable en gain et en phase, l'amplificateur multiport (MPA) comprenant une pluralité de ports d'entrées ($P_{E1}$, $P_{E2}$) et une pluralité de port de sorties ($P_{S1}$, $P_{S2}$), chaque port d'entrée étant associé à un port de sortie pour former un canal de transmission appelé « voie », chaque port de sortie étant reliée à une antenne du satellite ($Tx_1$, $Tx_2$), une première voie ($V_1$) étant configurée en fréquence dans un canal de transmission définissant une première bande utile pour recevoir des signaux en provenance d'une station émettrice ($STE_1$) au sol et les retransmettre après amplification dans l'amplificateur multiport (MPA) vers une première station terrestre ($STS_1$) d'une première zone géographique, un second port de sortie ($P_{S2}$) d'une seconde voie ($V_2$) étant configuré pour émettre via une seconde antenne ($Tx_2$) vers une seconde station terrestre ($STS_2$) d'une seconde zone géographique, ledit procédé étant **caractérisé par** :

   • une transmission d'un premier signal de test ($S_{E1}$) modulé par étalement de spectre de la première station émettrice ($STE_1$) vers la première voie ($V_1$) de l'amplificateur multiport (MPA), le premier signal de test étant généré dans au moins la bande utile de la première voie ($V_1$) ;
   • une réception par la seconde station réceptrice ($STS_2$) configurée en fréquence pour recevoir des signaux émis par la seconde antenne ($Tx_2$) reliée à la seconde voie ($V_2$) de l'amplificateur multiport (MPA), lesdits signaux étant susceptibles de comprendre une réplique du premier signal de test ($S_{E1}$) ;
• la détection et la mesure d'au moins une puissance de signaux reçus ($SS_2$) correspondant à une réplique du premier signal de test ($S_{E1}$) ayant fuité en sortie du second port de sortie ($P_{S2}$) ;
• un calcul d'au moins une valeur de déséquilibrage du MPA à partir de la mesure de la puissance de la réplique du premier signal de test ($S_{E1}$) reçue dans la seconde station terrestre ($STS_2$).

2. Procédé de détection d'un déséquilibrage d'un amplificateur multiport (MPA) selon la revendication 1, **caractérisé en ce que** le MPA comprend une matrice de Butler comprenant :

• un module d'entrée (IBM) permettant à partir du premier signal de test ($S_{E1}$) de générer une pluralité de composantes déphasées et de même amplitude vers une pluralité de chemins reliant le module d'entrée (IBM) à un module de sortie (OBM) ;
• une pluralité de chemins comprenant chacun au moins un amplificateur de signaux ;
• un module de sortie (OBM) permettant de diviser et recomposer les composantes entrantes déphasées et amplifiées de sorte à délivrer :

o dans un port de sortie ($P_{E1}$) donné, un signal ($BM(S_{E1})$) non nul amplifié correspondant au premier signal d'entrée ($S_{E1}$) à transmettre à la première station terrestre ($STS_1$) et ;
o dans les autres ports, des résultantes des composantes du premier signal de test ($S_{E1}$) sensiblement nulles aux erreurs de calibrations près.

3. Procédé de détection d'un déséquilibrage d'un amplificateur multiport (MPA) selon l'une quelconque des revendications 1 à 2, **caractérisé en ce que** le premier signal de test ($S_{E1}$) est un signal radiofréquence modulé par une séquence de bits de données codée par une séquence de pseudo bruit PN en bande de base, la séquence PN comprenant une taille N de symboles et un taux de codage $T_{Symbol}$, la dite séquence de pseudo bruit PN étant choisie parmi une famille de codes ayant chacune une propriété d'orthogonalité.

4. Procédé de détection d'un déséquilibrage d'un amplificateur multiport (MPA) selon la revendication 3, **caractérisé en ce que** l'orthogonalité d'une séquence correspond au résultat d'une autocorrélation de deux mêmes séquences dont l'une est décalée temporellement avec l'autre d'au moins la durée d'un symbole, le résultat de l'autocorrélation présentant un niveau sensiblement obtenu dans le niveau de bruit.

5. Procédé de détection d'un déséquilibrage d'un amplificateur multiport (MPA) selon la revendication 4, **caractérisé en ce que** la séquence de pseudo bruit PN est choisie:

▪ de manière que la longueur N de la séquence de pseudo bruit PN est calculée de sorte à obtenir un gain d'encodage (PG) supérieur à un seuil minimal, le gain d'encodage (PG) étant défini par le rapport entre le taux de codage d'un symbole ($T_{symbol}$) d'une séquence de pseudo bruit PN et le taux de codage ($T_{bit}$) d'un bit de données d'une séquence de bits de données ;
▪ parmi la liste suivante : {un code de type Gold codes, un code de type « Maximum Lengh Sequences », un code de type Walsh-Hadamard codes}.

6. Procédé de détection d'un déséquilibrage d'un amplificateur multiport (MPA) selon l'une quelconque des revendications 3 à 5, **caractérisé en ce que** le pic de l'autocorrélation d'une séquence de pseudo bruit est d'une valeur normée de 1 et qu'en dehors du pic de corrélation la valeur de la fonction d'autocorrélation est de l'ordre de 1/N.

7. Procédé de détection d'un déséquilibrage d'un amplificateur multiport (MPA) selon l'une quelconque des revendications 1 à 6, **caractérisé en ce que** :

▪ une première valeur seuil d'isolation entre la première antenne ($Tx_1$) de la première voie ($V_1$) et la seconde antenne ($Tx_2$) de la seconde voie ($V_2$) est respectée de sorte que la puissance reçue des signaux de la première antenne ($T_{x1}$) au niveau de la seconde station de réception ($STS_2$) soit considérée comme négligeable vis-à-vis de la puissance des signaux reçus pas la seconde station ($STS_2$) de réception ($STS2$) en provenance de la seconde antenne ($Tx_2$) ;
l'écart de puissance entre les signaux reçus par la seconde station ($STS_2$) en provenance de la première antenne ($T_{x1}$) et les signaux reçus pas la seconde station ($STS_2$) en provenance de la seconde antenne ($Tx_2$) est supérieure à un seuil prédéfini ;
▪ la première valeur seuil d'isolation est définie en comparant les puissances reçues dans un récepteur de la seconde station ($STS_2$) entre les signaux provenant d'une part de la première antenne ($Tx_1$) et d'autre part de la seconde antenne ($Tx_2$).

8. Procédé de détection d'un déséquilibrage d'un amplificateur multiport (MPA) selon l'une quelconque des revendications précédentes, **caractérisé en ce que** les signaux (SS$_1$, SS$_2$) en sortie d'au moins deux antennes (T$_{x1}$, T$_{x2}$) du MPA sont polarisés avec différentes polarisations de sorte à introduire entre les deux antennes correspondantes une isolation supplémentaire.

9. Procédé de détection d'un déséquilibrage d'un amplificateur multiport (MPA) selon l'une quelconque des revendications 1 à 8, **caractérisé en ce que** :

   ■ un retard à la sortie de l'une des voies (V$_1$, V$_2$) du MPA est introduit de sorte à retarder les signaux en sortie du port de sortie (P$_{S1}$, P$_{S2}$) de la voie correspondante (V$_1$, V$_2$) ;
   ■ une unique station terrestre (STS$_1$, STS$_2$) permet de recevoir les signaux en sortie de chaque port de sortie (P$_{S1}$, P$_{S2}$), l'orientation des premières et secondes antennes (T$_{x1}$, T$_{x2}$) permettant la réception des signaux (SS$_1$, SS$_2$) des premières et secondes voies (V$_1$, V$_2$) au niveau de la station terrestre (STS$_1$, STS$_2$),

   la durée du retard généré sur les signaux transmis étant supérieure à une durée minimale correspondant à la période d'un symbole (D$_{symbol}$) de la séquence PN du premier signal de test (S$_{E1}$).

10. Procédé de détection d'un déséquilibrage d'un amplificateur multiport (MPA) selon la revendication 9, **caractérisé en ce que** le retard est

   ■ Soit introduit par un retardateur (22) en sortie d'une des voies (V$_1$, V$_2$) du MPA ;
   ■ Soit introduit par une ligne à retard dont la longueur est dimensionnée pour introduire un retard souhaité ;
   ■ Soit généré au moyen d'une configuration d'un réseau de formation de faisceaux couplés avec les ports de sortie du MPA de sorte à attribuer pour chaque port de sortie des signaux comportant un déphasage prédéfini.

11. Procédé de détection d'un déséquilibrage d'un amplificateur multiport (MPA) selon l'une quelconque des revendications 9 à 10, **caractérisé en ce que** l'une des voies (V$_1$, V$_2$) du MPA est raccordé à une antenne de télémétrie ou une antenne cornet et qu'au moins un retardateur est agencé entre la voie et l'antenne de télémétrie ou de cornet.

12. Procédé de détection d'un déséquilibrage d'un amplificateur multiport (MPA) selon l'une quelconque des revendication 9 à 11, **caractérisé en ce que** le récepteur de la première station terrestre (STS$_1$, STS$_2$) procède à une fonction d'autocorrélation des signaux reçus de chacune des voies (SS$_1$, SS$_2$) sur une fenêtre de temps prédéfinie de sorte à discriminer la présence de chacune des séquences PN en réception, la discrimination des deux séquences résultant d'une isolation obtenue grâce au retard injecté dans l'une des voies du satellite.

13. Procédé de détection d'un déséquilibrage d'un amplificateur multiports (MPA) selon l'une quelconque des revendications précédentes, **caractérisé en ce que** le premier signal de test (S$_{E1}$) est transmis sur une voie (V$_1$) dans la même bande de fréquence que des signaux utiles de télécommunications.

14. Procédé de calibration d'un amplificateur multiport (MPA) d'un satellite (SAT), caractérisé en qu'il comprend :

   ■ une mesure d'un niveau de puissance de la réplique du premier signal de test sur un récepteur d'une station terrestre (STS$_2$) au moyen du procédé de détection d'un déséquilibrage d'un amplificateur multiport (MPA) selon l'une quelconque des revendications 1 à 13 ;
   ■ une génération d'au moins une consigne de calibration déduite des mesures de puissances du signal comprenant la réplique du premier signal de test (S$_{E1}$) ;
   ■ une transmission de ladite au moins une consigne de calibration au satellite, ladite consigne de calibration comprenant au moins une consigne de déphasage et/ou une consigne de gain.

15. Procédé de calibration d'un amplificateur multiport (MPA) d'un satellite (SAT) selon la revendication 14, caractérisé en que le récepteur de la station réceptrice (STS$_2$), mesurant la puissance d'un signal (SS$_2$) correspondant à une réplique du premier signal de test en sortie d'une seconde voie (V$_2$), transmet à une station de contrôle les données de puissances collectées de sorte à ce que la station de contrôle transmette un signal de commande au satellite (SAT) visant à reconfigurer le MPA avec les consignes de gain et/ou de déphasage générées.

**Patentansprüche**

1. Detektionsverfahren einer Fehlanpassung eines Multiport-Verstärkers (MPA), der zum Einbau auf einem Satelliten (SAT) bestimmt ist, wobei der Multiport-Verstärker eine Vielzahl von Wegen umfasst, wobei jeder Weg in der Verstärkung und in der Phase konfigurierbar ist, wobei der Multiport-Verstärker (MPA) eine Vielzahl von Eingangsports (P$_{E1}$, P$_{E2}$) und eine Vielzahl von Ausgangsports (P$_{S1}$, P$_{S2}$) umfasst, wobei jeder Eingangsport einem Ausgangsport zugeordnet ist, um einen als "Bahn" bezeichneten Übertragungskanal zu bilden, wobei jeder Ausgangsport einer Antenne des Satelliten (T$_{X1}$, T$_{X2}$)

zugeordnet ist, wobei eine erste Bahn ($V_1$) in Frequenz einem Übertragungskanal konfiguriert ist, der ein erstes Nutzband für den Empfang der aus einer Sendestation ($STE_1$) am Boden stammenden Signale definiert und um sie nach der Verstärkung in dem Multiport-Verstärker (MPA) in eine erste terrestrische Station ($STS_1$) einer ersten geographischen Zone weiterzuleiten, wobei ein zweiter Ausgangsport ($P_{S2}$) einer zweiten Bahn ($V_2$) konfiguriert ist, um über eine zweite Antenne ($TX_2$) zu einer zweiten terrestrischen Station ($STS_2$) einer zweiten geographischen Zone zu senden, wobei das genannte Verfahren **gekennzeichnet ist durch**:

• eine Übertragung eines ersten Testsignals ($S_{E1}$), das **durch** Spektrumspreizung des ersten Senderstation ($ST_{E1}$) zu der ersten Bahn ($V_1$) des Multiport-Verstärkers (MPA) moduliert ist, wobei das erste Testsignal in wenigstens dem Nutzband der ersten Bahn ($V_1$) generiert ist;
• einen Empfang **durch** die zweite Empfängerstation ($STS_2$), die in Frequenz konfiguriert ist, um Signale zu empfangen, die von der zweiten Antenne ($T_{x2}$) empfangen werden, die mit der zweiten Bahn ($V_2$) des Multiport-Verstärkers (MPA) verbunden ist, wobei die genannten Signale geeignet sind, eine Replik des ersten Testsignals ($S_{E1}$) zu umfassen;
• Detektion und Messung wenigstens einer Stärke empfangener Signale ($SS_2$), die einer Replik des ersten Testsignals ($S_{E1}$) entspricht, das am Ausgang des ersten Ausgangsports (PS2) ausgetreten ist;
• eine Berechnung wenigstens eines Fehlanpassungswertes des MPA ausgehend von der Messung der Stärke der Replik des ersten Testsignals ($S_{E1}$), das in der zweiten terrestrischen Station ($STS_2$) empfangen wird.

2. Detektionsverfahren einer Fehlanpassung eines Multiport-Verstärkers (MPA) gemäß Anspruch 1, **dadurch gekennzeichnet, dass** der MPA eine Butler-Matrix umfasst, umfassend

• ein Eingangsmodul (IBM), das ausgehend von dem ersten Testsignal ($S_{E1}$) das Generieren einer Vielzahl von phasenverschobenen Komponenten mit derselben Amplitude zu einer Vielzahl von Wegen zulässt, die das Eingangsmodul (IBM) mit einem Ausgangsmodul (OBM) verbinden;
• eine Vielzahl von Wegen, umfassend jeweils wenigstens einen Signalverstärker;
• ein Ausgangsmodul (OBM), das die Teilung und die erneute Zusammensetzung der eingehenden phasenverschobenen und verstärkten Komponenten derart zulässt, dass ausgegeben wird:

o ein verstärktes Signal ($BM(S_{E1})$) ungleich null in einem Ausgangsport ($P_{E1}$), das dem ersten Eingangssignal ($S_{E1}$) entspricht, das auf die erste terrestrische Station ($STS_1$) zu übertragen ist, und
o Resultanten der Komponenten des ersten Testsignals ($S_{E1}$), die bis an den Kalibrierungsfehlern deutlich null sind, in den anderen Ports.

3. Detektionsverfahren einer Fehlanpassung eines Multiport-Verstärkers (MDA) gemäß irgendeinem der Ansprüche 1 bis 2, **dadurch gekennzeichnet, dass** das erste Testsignal ($S_{E1}$) ein Funkfrequenzsignal ist, das durch eine Datenbit-Sequenz moduliert ist, die durch eine Pseudogeräuschsequenz PN im Basisband kodiert ist, wobei die Sequenz PN eine Größe von N von Symbolen und einen Codierungssatz $T_{Symbol}$ umfasst, wobei die genannte Pseudogeräuschsequenz PN aus einer Codefamilie ausgewählt ist, von denen jede eine Rechtwinkligkeitseigenschaft hat.

4. Detektionsverfahren einer Fehlanpassung eines Multiport-Verstärkers (MPA) gemäß Anspruch 3, **dadurch gekennzeichnet, dass** die Rechtwinkligkeit einer Sequenz dem Ergebnis einer Autokorrelation von zwei gleichen Sequenzen entspricht, von denen eine zeitlich mit der anderen um wenigstens die Dauer eines Symbols verschoben ist, wobei das Ergebnis der Autokorrelation ein Niveau aufweist, das deutlich in dem Geräuschpegel erhalten ist.

5. Detektionsverfahren einer Fehlanpassung eines Multiport-Verstärkers (MPA) gemäß Anspruch 4, **dadurch gekennzeichnet, dass** die Pseudogeräuschsequenz PN ausgewählt ist:

■ derart, dass die Länge N der Pseudogeräuschsequenz PN derart berechnet ist, dass eine Kodierungsverstärkung (PG) erhalten wird, die höher ist als ein minimaler Schwellenwert, wobei die Kodierungsverstärkung (PG) im Verhältnis zwischen dem Kodierungssatz eines Symbols ($T_{Symbol}$) einer Pseudogeräuschfrequenz PN und dem Kodierungssatz ($T_{Bit}$) eines Datenbits einer Datenbit-Sequenz definiert ist;
■ aus der folgenden Liste: {ein Code vom Typ Gold-Codes, ein Code vom Typ "Maximum Lengh Sequences", ein Code vom Typ Walsh-Hadamard Codes}.

6. Detektionsverfahren einer Fehlanpassung eines Multiport-Verstärkers (MPA) gemäß irgendeinem der Ansprüche 3 bis 5, **dadurch gekennzeichnet, dass** die Spitze der Autokorrelation einer Pseudogeräusch-Sequenz ein genormter Wert von 1 ist und dass außerhalb der Korrelationsspitze der Wert der Autokorrelationsfunktion in der Größenordnung von 1/N liegt.

7. Detektionsverfahren einer Fehlanpassung eines Multiport-Verstärkers (MPA) gemäß irgendeinem der Ansprüche 1 bis 6, **dadurch gekennzeichnet, dass**:

■ ein erster Isolationsschwellenwert zwischen der ersten Antenne ($T_{x1}$) der ersten Bahn ($V_1$) und der zweiten Antenne ($T_{x2}$) der zweiten Bahn ($V_2$) derart beachtet wird, dass die empfangene Stärke der Signale der ersten Antenne ($T_{x1}$) an der zweiten Empfangsstation ($STS_2$) gegenüber der Stärke der von der zweiten Empfangsstation ($STS_2$) des aus der zweiten Antenne ($Tx_2$) stammenden Empfangs ($STS_2$) empfangenen Signale als vernachlässigbar betrachtet wird;

■ der Stärkenunterschied zwischen den von der zweiten Station ($STS_2$) empfangenen, von der ersten Antenne ($T_{x1}$) stammenden Signale und den von der zweiten Station ($STS_2$), von der zweiten Antenne ($Tx_2$) stammenden empfangenen Signale größer ist als ein vorbestimmter Schwellenwert,

■ der erste Isolationsschwellenwert per Vergleich der Stärken definiert ist, die in einem Empfänger der zweiten Station ($STS_2$) zwischen den Signalen empfangen wird, die einerseits aus der ersten Antenne ($T_{x1}$) und andererseits aus der zweiten Antenne ($T_{x2}$) stammen.

8. Detektionsverfahren einer Fehlanpassung eines Multiport-Verstärkers (MPA) gemäß irgendeinem der voranstehenden Ansprüche, **dadurch gekennzeichnet, dass** die Signale ($SS_1$, $SS_2$) am Ausgang wenigstens von zwei Antennen ($Tx_1$, $Tx_2$) des MPA mit unterschiedlichen Polarisierungen derart polarisiert sind, dass zwischen den zwei entsprechenden Antennen eine zusätzliche Isolation eingeführt ist.

9. Detektionsverfahren einer Fehlanpassung eines Multiport-Verstärkers (MPA) gemäß irgendeinem der Ansprüche 1 bis 8, **dadurch gekennzeichnet, dass**:

■ eine Verzögerung am Ausgang einer der Bahnen ($V_1$, $V_2$) des MPA derart eingeführt ist, dass die Signale am Ausgang des Ausgangsports ($P_{S1}$, $Ps_2$) der entsprechenden Bahn ($V_1$, $V_2$) verzögert sind;

■ eine einzigartige terrestrische Station ($STS_1$, $STS_2$) den Empfang der Signale am Ausgang jedes Ausgangsports ($P_{S1}$, $P_{S2}$) zulässt, wobei die Ausrichtung der ersten und zweiten Antennen ($T_{x1}$, $T_{x2}$) den Empfang der Signale ($SS_1$, $SS_2$) der ersten und zweiten Bahnen ($V_1$, $V_2$) an

der terrestrischen Station ($STS_1$, $STS_2$) zulässt,

wobei die Dauer der auf den übertragenen Signalen generierten Verzögerung größer ist als eine minimale Dauer, die der Periode eines Symbols ($D_{symbol}$) der Sequenz PN des ersten Testsignals ($S_{E1}$) entspricht.

10. Detektionsverfahren einer Fehlanpassung eines Multiport-Verstärkers (MPA) gemäß Anspruch 9, **dadurch gekennzeichnet, dass** die Verzögerung :

■ entweder durch einen Verzögerer (22) am Ausgang einer der Bahnen (V1, V2) des MPA eingeführt ist;

■ oder durch eine Leitung mit Verzögerung eingeführt ist, deren Länge ausgelegt ist, um eine gewünschte Verzögerung einzuführen;

■ oder mittels einer Konfiguration eines Netzes zum Bilden von Bündeln generiert ist, die mit den Ausgangsports des MPA derart gekoppelt sind, dass jedem Ausgangsport Signale zuzuordnen sind, die eine vorbestimmte Phasenverschiebung umfassen.

11. Detektionsverfahren einer Fehlanpassung eines Multiport-Verstärkers (MPA) gemäß einem der Ansprüche 9 bis 10, **dadurch gekennzeichnet, dass** eine der Bahnen ($V_1$, $V_2$) des MPA an eine Telemetrie-Antenne oder einen Hornstrahler angeschlossen ist und dass wenigstens ein Verzögerer zwischen der Bahn der Telemetrie-Antenne oder dem Hornstrahler angeordnet ist.

12. Detektionsverfahren einer Fehlanpassung eines Multiport-Verstärkers (MPA) gemäß irgendeinem der Ansprüche 9 bis 11, **dadurch gekennzeichnet, dass** der Empfänger der ersten terrestrischen Station ($STS_1$, $STS_2$) eine Autokorrelationsfunktion der Signale vornimmt, die jeweils von den Bahnen ($SS_1$, $SS_2$) auf einem vorbestimmten Zeitfenster derart empfangen sind, dass das Vorhandensein jeder der Sequenzen PN beim Empfang diskriminiert ist, wobei die Diskriminierung der zwei Sequenzen aus einer Isolation resultiert, die dank der Verzögerung erhalten wird, die in eine der Bahnen des Satelliten eingeschossen wird.

13. Detektionsverfahren einer Fehlanpassung eines Multiport-Verstärkers (MPA) gemäß irgendeinem der voranstehenden Ansprüche, **dadurch gekennzeichnet, dass** das erste Testsignal ($S_{E1}$) auf eine Bahn ($V_1$) in demselben Frequenzband übertragen wird wie die Telekommunikationsnutzsignale.

14. Kalibrierungsverfahren eines Multiport-Verstärkers (MPA) eines Satelliten (SAT), **dadurch gekennzeichnet, dass** er umfasst:

▪ eine Messung eines Stärkeniveaus der Replik des ersten Testsignals auf einem Empfänger einer terrestrischen Station ($STS_2$) mittels des Detektionsverfahrens einer Fehlanpassung eines Multiport-Verstärkers (MPA) gemäß irgendeinem der Ansprüche 1 bis 13;

▪ ein Generieren wenigstens eines Kalibrierungssollwertes, der von den Stärkenmessungen des Signals abgezogen ist, umfassend die Replik des ersten Testsignals ($S_{E1}$):

▪ Eine Übertragung des genannten wenigstens einen Kalibrierungssollwertes auf den Satelliten, wobei der genannte Kalibrierungssollwert wenigstens einen Phasenverschiebungs- und / oder einen Verstärkungssollwert umfasst.

15. Kalibrierungsverfahren eines Multiport-Verstärkers (MPA) eines Satelliten (SAT) gemäß Anspruch 14, **dadurch gekennzeichnet, dass** der Empfänger der Empfangsstation ($STS_2$), der die Leistung eines Signals ($SS_2$) misst, das einer Replik des ersten Testsignals am Ausgang einer zweiten Bahn ($V_2$) entspricht, die erfassten Verstärkungsdaten derart auf eine Kontrollstation überträgt, dass die Kontrollstation ein Steuersignal auf den Satelliten (SAT) überträgt, der auf die Neukonfiguration des MPA mit den Verstärkungs- und / oder generierten Phasenverschiebungssollwerten abzielt.

**Claims**

1. Method for detecting an imbalance of a multiport amplifier (MPA) intended to be placed on board a satellite (SAT), with the multiport amplifier comprising a plurality of paths, each path able to be configured in gain and in phase, the multiport amplifier (MPA) comprising a plurality of input ports ($P_{E1}$, $P_{E2}$) and a plurality of output ports ($P_{S1}$, $P_{S2}$), each input port being associated with an output port in order to form a transmission channel called "channel", each output port being connected to an antenna of the satellite ($Tx_1$, $Tx_2$), a first channel ($V_1$) being configured in frequency in a transmission channel defining a first useful band in order to receive signals coming from an emitting station ($STE_1$) on the ground and for retransmitting them after amplification in the multiport amplifier (MPA) to a first ground station ($STS_1$) of a first geographical zone, a second output port ($P_{S2}$) of a second channel ($V_2$) being configured to emit via a second antenna ($Tx_2$) to a second ground station ($STS_2$) of a second geographical zone, said method **characterised by**:

• a transmitting of a first test signal ($S_{E1}$) modulated by spectrum spreading of the first emitting station ($STE_1$) to the first channel ($V_1$) of the multiport amplifier (MPA), the first test signal being generated in at least the useful band of the first channel ($V_1$);
• a receiving by the second receiving station ($STS_2$) configured in frequency to receive signals emitted by the second antenna ($Tx_2$) connected to the second channel ($V_2$) of the multiport amplifier (MPA), said signals able to include a replica of the first test signal ($S_{E1}$);
• the detecting and the measuring of at least one power of the signals received ($SS_2$) corresponding to a replica of the first test signal ($S_{E1}$) having leaked at the output of the second output port ($P_{S2}$);
• a calculating of at least one imbalancing value of the MPA using the measurement of the power of the replica of the first test signal ($S_{E1}$) received in the second ground station ($STS_2$).

2. Method for detecting an imbalance of a multiport amplifier (MPA) according to claim 1, **characterised in that** the MPA comprises a Butler matrix comprising:

• an input module (IBM) that makes it possible using the first test signal ($S_{E1}$) to generate a plurality of shifted components and of the same amplitude to a plurality of paths connecting the input module (IBM) to an output module (OBM);
• a plurality of paths each comprising at least one signal amplifier;
• an output module (OBM) making it possible to divide and recompose the incoming shifted components and amplified in such a way as to deliver:

o in a given output port ($P_{E1}$), an amplified non-zero signal ($BM(S_{E1})$) corresponding to the first input signal ($S_{E1}$) to be transmitted to the first ground station ($STS_1$) and;
o in the other ports, results of the components of the first test signal ($S_{E1}$) substantially zero to the nearest calibration errors.

3. Method for detecting an imbalance of a multiport amplifier (MPA) according to any of claims 1 to 2, **characterised in that** the first test signal ($S_{E1}$) is a radiofrequency signal modulated by a sequence of data bits encoded by a sequence of pseudo noise PN in baseband, with the sequence PN comprising a size N of symbols and an encoding rate $T_{Symbol}$, with said sequence of pseudo noise PN being chosen from a family of codes with each one having a property of orthogonality.

4. Method for detecting an imbalance of a multiport amplifier (MPA) according to claim 3, **characterised in that** the orthogonality of a sequence corresponds to the result of an autocorrelation of two same sequences of which one is time shifted with the other by at least the duration of a symbol, with the result of the autocorrelation having a level substantially obtained ion the noise level.

5.  Method for detecting an imbalance of a multiport amplifier (MPA) according to claim 4, **characterised in that** the sequence of pseudo noise PN is chosen:

    • in such a way that the length N of the sequence of pseudo noise PN is calculated in such a way as to obtain an encoding gain (PG) greater than a minimum threshold, with the encoding gain (PG) being defined by the ratio between the encoding rate of a symbol ($T_{symbol}$) of a sequence of pseudo noise PN and the encoding rate ($T_{bit}$) of a data bit of a sequence of data bits;
    • from the following list: {a code of the Gold code type, a code of the "Maximum Length Sequences" type, a code of the Walsh-Hadamard type}.

6.  Method for detecting an imbalance of a multiport amplifier (MPA) according to any of claims 3 to 5, **characterised in that** the autocorrelation peak of a sequence of pseudo noise is of a standardised value of 1 and that outside of the correlation peak the value of the autocorrelation functions is about 1/N.

7.  Method for detecting an imbalance of a multiport amplifier (MPA) according to any of claims 1 to 6, **characterised in that**:

    • a first insulation threshold value between the first antenna ($Tx_1$) of the first channel ($V_1$) and the second antenna ($Tx_2$) of the second channel ($V_2$) is respected in such a way that the power received from the signals of the first antenna ($T_{x1}$) on the second receiving station ($STS_2$) is considered to be negligible with respect to the power of the signals received by the second station ($STS_2$) for receiving (STS2) coming from the second antenna ($Tx_2$);

    the difference in power between the signals received by the second station ($STS_2$) coming from the first antenna ($T_{x1}$) and the signals received by the second station ($STS_2$) coming from the second antenna ($T_{x2}$) is greater than a predefined threshold;

    • the first insulation threshold value is defined by comparing the powers received in a receiver of the second station ($STS_2$) between the signals coming on the one hand from the first antenna ($Tx_1$) and on the other hand from the second antenna ($Tx_2$)

8.  Method for detecting an imbalance of a multiport amplifier (MPA) as claimed in any preceding claim, **characterised in that** the signals ($SS_1$, $SS_2$) at the output of at least two antennas ($T_{x1}$, $T_{x2}$) of the MPA are polarised with different polarisations in such a way as to introduce between the two corresponding antennas an additional insulation.

9.  Method for detecting an imbalance of a multiport amplifier (MPA) according to any of claims 1 to 8, **characterised in that**:

    • a delay at the output of one of the channels ($V_1$, $V_2$) of the MPA is introduced in such a way as to delay the signals at the output of the output port ($P_{S1}$, $P_{S2}$) of the corresponding channel ($V_1$, $V_2$);
    • a single ground station ($STS_1$, $STS_2$) makes it possible to receive the signals at the output of each output port ($P_{S1}$, $P_{S2}$), with the orientation of the first and second antennas ($T_{X1}$, $T_{X2}$) allowing for the reception of the signals ($SS_1$, $SS_2$) of the first and second channels ($V_1$, $V_2$) on the ground station ($STS_1$, $STS_2$),

    the duration of the delay generated on the transmitted being greater than a minimum duration corresponding to the period of one symbol ($D_{symbol}$) of the sequence PN of the first test signal ($S_{E1}$).

10. Method for detecting an imbalance of a multiport amplifier (MPA) according to claim 9, **characterised in that** the delay is

    • Either introduced by a timer (22) at the output of one of the channels ($V_1$, $V_2$) of the MPA;
    • Or introduced by a delay line of which the length is dimensioned to introduce a desired delay;
    • Or generated by means of a configuration of a beam forming network coupled with the output ports of the MPA in such a way as to attribute for each output port signals comprising a predefined shift.

11. Method for detecting an imbalance of a multiport amplifier (MPA) according to any of claims 9 to 10, **characterised in that** one of the channels ($V_1$, $V_2$) of the MPA is connected to a telemetry antenna or a horn antenna and that at least one timer is arranged between the channel and the telemetry or horn antenna.

12. Method for detecting an imbalance of a multiport amplifier (MPA) according to any of claims 9 to 11, **characterised in that** the receiver of the first ground station ($STS_1$, $STS_2$) carries out an autocorrelation function of the signals received from each one of the channels ($SS_1$, $SS_2$) over a predefined time window in such a way as to discriminate the presence of each one of the sequences PN at reception, with the discrimination of the two sequences resulting from an isolation obtained thanks to the delay injected into one of the channels of the satellite.

13. Method for detecting an imbalance of a multiport amplifier (MPA) as claimed in any preceding claim, **characterised in that** the first test signal ($S_{E1}$) is transmitted on one channel ($V_1$) in the same frequency band as the useful telecommunications signals.

14. Method for calibrating a multiport amplifier (MPA) of a satellite (SAT), **characterised in that** it comprises:

> • a measuring of the power level of the replica of the first test signal on a receiver of a ground station ($STS_2$) by means of the method for detecting an imbalance of a multiport amplifier (MPA) according to any of claims 1 to 13;
> • a generating of at least one calibration setting deduced from the measurements of the powers of the signal comprising the replica of the first test signal ($S_{E1}$);
> • a transmitting of said at least one calibration setting to the satellite, said calibration setting comprising at least one shift setting and/or one gain setting.

15. Method for calibrating a multiport amplifier (MPA) of a satellite (SAT) according to claim 14, **characterised in that** the receiver of the receiving station ($STS_2$), measuring the power of a signal ($SS_2$) corresponding to a replica of the first test signal at the output of a second channel ($V_2$), transmits to a control station the power data collected in such a way that the control station transmits a control signal to the satellite (SAT) aimed at reconfiguring the MPA with the gain and/or shift settings generated.

FIG. 1

FIG. 2

FIG.3A

FIG. 3B

FR$_{TX11}$

DE$_{TX22}$

SS$_2$

41

42

43

SS$_1$'

FR$_{TX12}$

ZONE FR
(STS$_1$)

ZONE DE
(STS$_2$)

FIG. 4

FIG. 5

**EP 2 916 470 B1**

**Documents brevets cités dans la description**

- US 20100148860 A